# EUROPEAN PATENT SPECIFICATION

(11) **EP 0 270 231 B1**
(45) Date of publication and mention of the grant of the patent: **10.03.1993**
(21) Application number: 87309389.2
(22) Date of filing: 23.10.1987
(51) Int. Cl.: C23C 18/12, H01L 21/312, H01L 21/314

(54) **Platinum or rhodium catalyzed multilayer ceramic coatings from hydrogen silsequioxane resin and metal oxides**
Mehrlagige keramische Beschichtungen aus Wasserstoff-Silsesquioxanharz und Metalloxiden, katalysiert durch Platin und Rhodium
Revêtement multicouche en céramique à partir de résine hydrogène-silsesquioxane et d'oxydes métalliques catalysé par du platine ou du rhodium

(30) Priority: 04.12.1986 US 938678
(43) Date of publication of application: 08.06.1988
(73) Proprietor: DOW CORNING CORPORATION, Midland Michigan 48686-0995 (US)
(72) Inventor: Haluska, Loren Andrew, Midland, MI (US); Michael, Keith Winton, Midland, MI (US); Tarhay, Leo, Sanford, MI (US)
(74) Representative: Kyle, Diana

(56) References cited:
- EP-A- 0 076 656
- GB-A- 2 125 423
- PATENT ABSTRACTS OF JAPAN, vol.7, no. 158 (E-186)( 1303), 12 July 1983#
- PATENT ABSTRACTS OF JAPAN, vol. 9, no. 230 (E-343)(1953),17 September 1985#

## Description

Electronic devices, to be serviceable under a wide variety of environmental conditions, must be able to withstand moisture, heat, and abrasion resistance, among other stresses. A significant amount of work has been reported directed toward the preparation of coatings for electronic devices which can increase the reliability of the devices. None of the conventional coatings available today, including ceramic and metal packaging, can perform well enough by itself to protect an electronic device against all environmental stresses.

A common cause of failure of electronic devices is microcracks or voids in the surface passivation of the semiconductor chip allowing the introduction of impurities. Thus a need exists for a method which will overcome the formation of microcracks, voids or pinholes in inorganic coatings of electronic devices.

Passivating coatings on electronic devices can provide barriers against ionic impurities, such as chloride ion (Cl-) and sodium ion (Na+), which can enter an electronic device and disrupt the transmission of electronic signals. The passivating coating can also be applied to electronic devices to provide some protection against moisture and volatile organic chemicals.

Amorphous silicon (hereinafter a-Si) films have been the subject of intense research for various applications in electronic industries, however, the use of a-Si films for environmental or hermetic protection of electronic devices is unknown. A number of possible processes have been previously disclosed for forming a-Si films. For instance, for producing films of amorphous silicon, the following deposition processes have been used: chemical vapor deposition (CVD), plasma enhanced CVD, reactive sputtering, ion plating and photo-CVD, etc. Generally, the plasma enhanced CVD process is industrialized and widely used for depositing a-Si films.

Known to those skilled in the art is the utility of substrate planarization as an interlayer within the body of an electronic device and between the metallization layers. Gupta and Chin (Microelectronics Processing, Chapter 22, "Characteristics of Spin-On Glass Films as a Planarizing Dielectric", pp349-65, American Chemical Society, 1986) have shown multilevel interconnect systems with isolation of metallization levels by conventional interlevel dielectric insulator layers of doped or undoped SiO₂ glass films. However, CVD dielectric films provide only at best a conformal coverage of substrate features which is not conducive to continuous and uniform step coverage by an overlying metallization layer. The poor step coverage results in discontinuous and thin spots in the conductor lines causing degradation of metallization yields as well as device reliability problems. Spin-on glass films have been utilized to provide interlayer isolation between the metallization layers, the top layer of which is later patterned by lithographic techniques. Topcoat planarization on the surface of an electronic device as opposed to planarizing interlevel dielectric layers, however, is unknown.

Under the teachings of the prior art, a single material most often will not suffice to meet the ever increasing demands of specialty coating applications, such as those found in the electronics industry. Several coating properties such as microhardness. moisture resistance, ion barrier, adhesion, ductility, tensile strength, thermal expansion coefficients, etc., need to be provided by successive layers of different coatings.

Silicon and nitrogen-containing preceramic polymers, such as silazanes have been disclosed in various patents, including U.S. Patent No. 4,404,153, issued September 13, 1983 to Gaul, wherein there is disclosed a process for preparing Rʹ₃SiNH-containing silazane polymers by contacting and reacting chlorine-containing disilanes with (Rʹ₃Si)₂NH where Rʹ is vinyl, hydrogen, an alkyl radical of 1 to 3 carbon atoms or the phenyl group. Gaul also teaches therein the use of the preceramic silazane polymers to produce silicon carbon nitrogen-containing ceramic materials.

Gaul in U.S. Patent 4,312,970, issued January 26, 1982, obtained ceramic materials by the pyrolysis of preceramic silazane polymers, which polymers were prepared by reacting organochlorosilanes and disilazanes.

Gaul in U.S. Patent 4,340,619, issued July 20, 1982, obtained ceramic materials by the pyrolysis of preceramic silazane polymers, which polymers were prepared by reacting chlorine-containing disilanes and disilazanes.

Cannady in U.S. Patent 4,540,803, issued September 10, 1985, obtained ceramic materials by the pyrolysis of preceramic silazane polymers, which polymers were prepared by reacting trichlorosilane and disilazanes.

Frye and Collins teach in United States Patent No. 3,615,272, issued October 26, 1971, and also in Frye et al., J. Am. Chem. Soc., 92, p.5586, 1970, the formation of hydrogen silsesquioxane resin.

Dietz et al., United States Patent No. 3,859,126, issued January 7, 1975, teaches the formation of a composition comprising PbO, B₂O₃, and ZnO, with optional various oxides including SiO₂.

Rust et al., United States Patent No. 3,061,587, issued October 30, 1963, teaches a process for forming ordered organo silicon-aluminum oxide copolymers by reacting dialkyl diacyloxysilane or dialkyl dialkoxysilane, with trialkylsiloxy dialkoxy aluminum.

The instant invention relates to the enhancement of the protection of substrates such as electronic devices by the low temperature formation of thin mono- or multilayer ceramic or ceramic-like coatings on the surface of the device. What has been discovered is a method of forming coatings from hydrogen silsesquioxane resin and one or more metal oxides, which are subsequently coated with one or more silicon, or silicon and nitrogen, or silicon and carbon and nitrogen-containing, ceramic or ceramic-like coatings.

The instant invention relates to the low temperature formation of monolayer and multilayer protective coatings for the protection of substrates such as electronic devices. The monolayer coatings of the present invention consist of a coating prepared by contacting platinum or rhodium catalyzed hydrogen silsesquioxane resin, (HSiO_{3/2})ₙ, with zirconium, aluminum, and/or titanium alkoxides to produce a homogeneous preceramic polymer material. The dual-layer coatings of the present invention consist of (1) a coating prepared by contacting platinum or rhodium catalyzed hydrogen silsesquioxane resin, (HSiO_{3/2})ₙ, with zirconium, aluminum, and/or titanium alkoxides and (2) a topcoat of silicon-containing material, or silicon nitrogen-containing material, or silicon carbon containing material, derived by heating a silane, halosilane, halodisilane, halopolysilane or mixture thereof to provide protection. The first layer is a SiO₂/TiO₂, or SiO₂/ZrO₂, or SiO₂/TiO₂/ZrO₂, or SiO₂/Al₂O₃, or SiO₂/TiO₂/ZrO₂/Al₂O₃ planarizing and passivating coating that is applied by known techniques, including flow coating, spin coating, dip coating and spray coating of an electronic device and then ceramifying. The second layer of the dual-layer coatings of the instant invention is a protective barrier coating of silicon-containing material derived from the CVD or plasma enhanced CVD of silanes, alkylsilanes, halosilanes, halodisilanes, silazanes, or mixtures of alkanes, silanes, and ammonia.

The instant invention also relates to the low temperature formation of a three layer coating system for substrates such as electronic devices wherein the first layer is a platinum or rhodium catalyzed SiO₂/TiO₂, SiO₂/ZrO₂, SiO₂/TiO₂/ZrO₂, SiO₂/Al₂O₃ or SiO₂/TiO₂/ZrO₂/Al₂O₃ coating. The second layer, used for passivation, is a ceramic or ceramic-like coating obtained by the ceramification of a preceramic silicon nitrogen-containing polymer coating, or is a silicon nitrogen-containing, silicon carbon nitrogen-containing, or silicon carbon-containing layer deposited by thermal, UV, CVD, plasma enhanced CVD or laser techniques. The third layer in the three layer coatings of the present invention is a top coating of (a) silicon-containing material applied by CVD, plasma enhanced CVD, or metal assisted CVD of a halosilane, halodisilane, halopolysilane, or mixtures thereof, or (b) silicon carbon-containing material, applied by CVD or plasma enhanced CVD of a halosilane, halodisilane, halopolysilane, or mixtures thereof, and an alkane, or (c) silicon nitrogen-containing material applied by CVD or plasma enhanced CVD of a silane, halosilane, halodisilane, halopolysilane, or mixtures thereof, and ammonia, or (d) silicon carbon nitrogen-containing material applied by CVD or plasma enhanced CVD of hexamethyldisilazane or CVD or plasma enhanced CVD of mixtures of a silane, an alkylsilane, an alkane and ammonia.

The instant invention relates to the discovery that platinum or rhodium catalyzed hydrogen silsesquioxane resin, (HSiO_{3/2})ₙ, can be contacted with zirconium, aluminum or titanium alkoxides to prepare novel preceramic polymers that can be converted at low temperatures to ceramic or ceramic-like materials useful as planarizing coatings for irregular surfaces of electronic devices. In the instant invention, by "alkoxide" is meant any alkoxy, acyloxy, dialkoxy, trialkoxy, or tetraalkoxy organic group which is bonded to a metal and which can be hydrolyzed and subsequently pyrolyzed under the ceramification conditions stated herein to produce a metal oxide. By the instant invention, ceramic or ceramic-like planarizing coating compositions such as SiO₂/ZrO₂, SiO₂/TiO₂, SiO₂/TiO₂/ZrO₂, and SiO₂/Al₂O₃ have been prepared. These metal oxide ceramic or ceramic-like coatings minimize mechanical stresses due to the irregular topography of an integrated circuit or electronic device and also help prevent microcracking of subsequent multilayer coatings under thermal cycling conditions.

The use of platinum catalysts, such as, for example, (CH₃CH₂S)₂PtCl₂, and Pt(CH₃CH(O)CHCH(O)CH₃)₂, or rhodium catalyst, such as RhCl₃(CH₃CH₂CH₂CH₂S)₃, in the instant invention enhances the oxidation and cure of the (HSiO_{3/2})ₙ resin. In addition, the platinum and/or rhodium catalysis of the instant invention assists in the reduction or elimination of residual SiH functionality on the (HSiO_{3/2})ₙ resin, further increasing the production of SiO₂. Furthermore, catalysis of the hydrogen silsesquioxane resin planarizing layer with platinum and/or rhodium complexes significantly reduces the weight loss observed on curing.

In the instant invention, by "ceramic-like" is meant those pyrolyzed silicon-nitrogen containing materials which are not fully free of residual carbon and/or hydrogen but which are otherwise ceramic-like in character. By "electronic device" in the instant invention is meant devices including, but not limited to, electronic devices, silicon based devices, gallium arsenide devices, focal plane arrays, opto-electronic devices, photovoltaic cells and optical devices.

The preceramic hydrogen silsesquioxane resin material can be prepared by the method of Frye et al. United States Patent No. 3,615,272, issued October 26, 1971.

The invention further relates to the discovery that these ceramics can be used as coatings for multilayer electronic devices as well as other integrated circuits. The coatings of the instant invention are also useful for functional purposes not related to protection of the substrate, such as, dielectric layers, doped dielectric layers to produce transistor-like devices, pigment loaded binder systems containing silicon to produce capacitors and capacitor-like devices, multilayer devices, 3-D devices, silicon-on-insulator (SOI) devices, super lattice devices and the like.

It is an object of the instant invention to provide a process to produce ceramic or ceramic-like planarizing coatings from carbon-free precursor materials. This is achieved according to the process of the present invention by the use of platinum and/or rhodium catalyzed hydrogen silsesquioxane resin (HSiO_{3/2})ₙ solution deposited onto a substrate and ceramified as defined in claim 1. Preferred embodiments of the invention are defined in the dependent claims 2-14.

The instant invention further relates to the discovery that these catalyzed silicon dioxide (SiO₂-containing) ceramic or ceramic-like coatings can be coated with various silicon, carbon and/or nitrogen-containing materials for the protection of substrates such as electronic devices as well as other integrated circuits.

The instant invention also relates to the formation of silicon- and nitrogen-containing passivating coatings and silicon-containing top coatings for substrates such as ceramic or ceramic-like coated electronic devices whereby the top coating is prepared by CVD, plasma enhanced CVD or metal catalyzed CVD techniques.

The monolayer coatings of the present invention are produced by coating a substrate with a planarizing coating by means of diluting with a solvent a preceramic mixture of hydrogen silsesquioxane resin and a metal oxide precursor selected from the group consisting of an aluminum alkoxide, a titanium alkoxide, and a zirconium alkoxide, catalyzing the diluted preceramic mixture solution with a metal catalyst selected from the group consisting of platinum catalysts and rhodium catalysts, and coating a substrate with the diluted catalyzed preceramic mixture solution, drying the diluted catalyzed preceramic mixture solution so as to evaporate the solvent and thereby deposit a catalyzed preceramic coating on the substrate, ceramifying the preceramic coating to silicon dioxide and metal oxide by heating the coated substrate to a temperature between 150 and 1000°C to produce a monolayer ceramic or ceramic-like coating on the substrate.

The coatings produced by the instant invention exhibit strong adhesion to many substrates including, but not limited to, electronic devices, and are abrasion and moisture resistant. The choice of substrates and devices to be coated by the instant invention is limited only by the need for thermal and chemical stability of the substrate at the lower decomposition temperature in the atmosphere of the decomposition vessel.

According to a particular embodiment, the instant invention relates to a method of forming a multilayer, ceramic or ceramic-like, coating which method comprises (A) coating a substrate with a planarizing coating by means of diluting with a solvent a preceramic mixture of hydrogen silsesquioxane resin and a metal oxide precursor selected from the group consisting of an aluminum alkoxide, titanium alkoxide, and zirconium alkoxide, catalyzing the diluted preceramic mixture solution with a metal catalyst selected from the group consisting of platinum catalysts and rhodium catalysts, coating an substrate with said diluted catalyzed preceramic mixture solution, drying the diluted catalyzed preceramic mixture solution so as to evaporate the solvent and thereby deposit a homogeneous catalyzed preceramic coating on the substrate, ceramifying the preceramic coating to silicon dioxide and metal oxide by heating the coated substrate to a temperature between 150 and 1000°C to produce a ceramic or ceramic-like coating, and (B) applying to the ceramic or ceramic-like coating on the substrate a silicon-containing coat by means of decomposing in a reaction chamber a silane, halosilane, halodisilane or mixture thereof in the vapor phase, at a temperature between 150 and 1000°C., in the presence of the ceramic coated device, whereby a substrate containing a multilayer, ceramic, coating thereon is obtained. The method for coating the substrate with the preceramic solvent solution can be, but is not limited to, flow coating, spin coating, spray or dip coating techniques.

According to another embodiment of the instant invention there is provided a method of forming a multilayer, ceramic or ceramic-like, protective coating comprising (A) coating a substrate with a coating by means of diluting to low solids in a solvent a hydrogen silsesquioxane preceramic mixture, which has been contacted with tetra n-propoxy zirconium, catalyzing the diluted preceramic mixture solution with a metal catalyst selected from the group consisting of platinum catalysts and rhodium catalysts, coating a substrate with said diluted catalyzed preceramic mixture solution, drying the diluted catalyzed preceramic mixture solution so as to evaporate the solvent and thereby deposit a catalyzed preceramic coating on the substrate, ceramifying the preceramic coating to silicon dioxide and zirconium dioxide by heating the coated substrate to produce a ceramic or ceramic-like coating, and (B) applying to the ceramic or ceramic-like coating on the substrate a silicon-containing coating by means of decomposing in a reaction chamber a silane, halosilane, halodisilane or mixture of halosilanes in the vapor phase, at a temperature between 200 and 600°C preferably between 200 and 400°C., in the presence of the coated substrate whereby a substrate, containing a multilayer, ceramic or ceramic-like, protective coating thereon is obtained.

The instant invention further relates, in another aspect, to a method of forming a multilayer, ceramic or ceramic-like coating which method comprises (A) coating a substrate with a coating by means of diluting to low solids in a solvent a hydrogen silsesquioxane preceramic polymer resin mixture, which has been contacted with tetra isobutoxy titanium, catalyzing the diluted preceramic mixture solution with a metal catalyst selected from the group consisting of platinum catalysts and rhodium catalysts, coating a substrate with said diluted catalyzed preceramic mixture solution, drying the diluted catalyzed preceramic mixture solution so as to evaporate the solvent and thereby deposit a preceramic catalyzed coating on the substrate, ceramifying the preceramic coating to silicon dioxide and titanium dioxide by heating the coated substrate to produce a ceramic or ceramic-like coating, and (B) applying to the coated substrate a silicon-containing coating by means of decomposing in a reaction chamber a silane, halosilane, halodisilane or mixture of halosilanes in the vapor phase, at a temperature between 200 and 600°C preferably between 200 and 400°C., in the presence of the coated substrate whereby a substrate containing a multilayer, ceramic or ceramic-like coating thereon is obtained.

According to a further aspect of the instant invention a method of forming a multilayer, ceramic or ceramic-like coating is provided which method comprises (A) coating a substrate with a coating by means of diluting to low solids in a solvent a hydrogen silsesquioxane preceramic polymer resin mixture, which has been contacted with an aluminum alkoxide, catalyzing the diluted preceramic mixture solution with a metal catalyst selected from the group consisting of platinum catalysts and rhodium catalysts, coating a substrate with said diluted catalyzed preceramic mixture solution, drying the diluted catalyzed preceramic mixture solution so as to evaporate the solvent and thereby deposit a preceramic coating on the substrate, ceramifying the preceramic coating to silicon dioxide and aluminum oxide by heating the coated device to produce a ceramic or ceramic-like coating, and (B) applying to the ceramic or ceramic-like coating on the substrate a silicon-containing coating by means of decomposing in a reaction chamber a silane, halosilane, halodisilane or mixture of halosilanes in the vapor phase, at a temperature between 200 and 600°C preferably between 200 and 400°C., in the presence of the coated substrate, whereby a substrate containing a multilayer, ceramic or ceramic-like protective coating thereon is obtained.

The instant invention still further relates, in another embodiment, to a method of forming a multilayer, ceramic or ceramic-like coating which method comprises (A) coating a substrate with a coating by means of diluting with a solvent a preceramic mixture of hydrogen silsesquioxane resin and a metal oxide precursor selected from the group consisting of an aluminum alkoxide, titanium alkoxide, and zirconium alkoxide, catalyzing the diluted preceramic mixture solution with a metal catalyst selected from the group consisting of platinum catalysts and rhodium catalysts, coating a substrate with said diluted catalyzed preceramic mixture solution, drying the diluted catalyzed preceramic mixture solution so as to evaporate the solvent and thereby deposit a catalyzed preceramic coating on the substrate, ceramifying the catalyzed preceramic coating to silicon dioxide and metal oxide by heating the coated device to produce a ceramic or ceramic-like coating, and (B) applying to the coated substrate a passivating coating which comprises a silicon nitrogen-containing material by means of diluting to low solids in a solvent a preceramic silicon nitrogen-containing polymer, coating the ceramic coated substrate with the diluted preceramic silicon nitrogen-containing polymer solution, drying the diluted preceramic silicon nitrogen-containing polymer solution so as to evaporate the solvent and thereby deposit a preceramic silicon nitrogen-containing coating on the coated substrate, heating the coated substrate in an inert or ammonia-containing atmosphere to produce a ceramic or ceramic-like silicon nitrogen-containing coating, and (C) applying to the coated substrate a silicon-containing coating by means of decomposing in a reaction chamber a silane, halosilane, halodisilane, halopolysilane or mixture thereof in the vapor phase, at a temperature between 150 and 1000°C preferably between 200 and 900°C., in the presence of the coated device, whereby a substrate containing a multilayer, ceramic or ceramic-like coating thereon is obtained.

The ceramification of the planarizing and passivating coatings utilized in the multilayer coatings of the instant invention can be achieved at temperatures between 150 and 1000°C. and preferably at temperatures between 200 and 600°C most preferably between 200 and 400°C.

In a particular aspect of the instant invention, a preceramic polymer containing hydrogen silsesquioxane resin, (HSiO_{3/2})ₙ, which can be prepared by the method of Frye et al., U.S. Patent No. 3,615,272, is diluted after the incorporation of, for example, tetra n-propoxy zirconium , Zr(OCH₂CH₂CH₃)₄, or tetra isobutoxy titanium, Ti(OCH₂CH(CH₃)₂)₄, to low solids (eg., 0.1 to 10 weight percent) in a solvent such as toluene, methyl ethyl ketone, or n-heptane. To the solution is added the platinum or rhodium catalyst in the form of, for example, 60 parts per million of (CH₃CH₂S)₂PtCl₂ in 0.01 gram of toluene. The diluted catalyzed preceramic polymer solvent solution is then coated onto an electronic device and the solvent allowed to evaporate by drying. The method of coating the diluted preceramic polymer solution onto the electronic device can be, but is not limited to, spin coating, dip coating, spray coating, or flow coating. By this means is deposited a homogeneous catalyzed preceramic coating which is ceramified by heating the coated device for approximately twenty hours at 200°C. or for one hour at 400°C. This represents a significant processing temperature reduction over that of the prior art. Thin ceramic or ceramic-like planarizing coatings of less than 2 µm (2 microns), for example, approximately 0.5 µm (5000 A) are thus produced on the devices. The planarizing coatings thus produced can then be coated with a passivating silicon nitrogen-containing coating of the present invention or with a CVD or PECVD applied silicon-containing coating, silicon carbon-containing coating, silicon nitrogen-containing coating, silicon carbon nitrogen-containing coating, or a combination of these coatings.

Another significant result of catalyzing the silsesquioxane resin with platinum and/or rhodium is the beneficial reduction in the amount of weight loss observed on exposure to elevated temperatures. Thus, the silsesquioxane resin exposed to increasing temperatures in thermogravimetric analysis (TGA under a helium atmosphere but in absence of platinum catalyst, exhibited a 20% weight loss while the silsesquioxane resin catalyzed with the platinum catalyst exhibited only a 14% weight loss. The significant improvement of 6% in reduction of weight loss resulting from the platinum catalyst is indicative of improved crosslinking of the resin to form higher molecular weight polymers with higher char yields, a feature important in ceramification.

Furthermore, TGA experiments run in air on the uncatalyzed and platinum catalyzed silsesquioxane resin demonstrate a 9% weight loss in the former but a 6% weight gain in the latter, i.e., the catalyzed sample displayed an initial 4% loss as unreacted material volatilized but upon continued heating from about 400 to 1000°C. the sample gained 6% weight above the starting weight as a result of oxidation.

With rhodium catalysis, another sample of hydrogen silsesquioxane resin heated to 1000°C. under helium exhibited a 30% weight loss but a 68% weight loss was observed under identical conditions without the rhodium catalysis. When catalyzed with rhodium and oxidized in air, the hydrogen silsesquioxane resin exhibited a 7% weight gain, similar to the gain observed with platinum catalysis, due to oxygen incorporation. However, in the absence of rhodium catalyst, the same resin lot showed a 28% weight loss upon heating to 1000°C. in air.

Thus, the platinum catalyst or rhodium catalyst facilitates the oxidation of any residual SiH moieties first to SiOH and then further to SiOSi. This oxidative weight gain phenomenon was not observed in the uncatalyzed silsesquioxane resin samples. The higher molecular weights and reduction in weight loss achievable by the present invention are important advances over the prior art because subsequent ceramification of the higher molecular weight polymers can produce higher ceramic yields.

The cure of the hydrogen silsesquioxane resin is not limited herein to oxidative curing in air. The above discussion illustrates the utility of the present invention to cure the hydrogen silsesquioxane resin with platinum catalysts or rhodium catalysts in the absence of air. In addition, the resin can be cured with platinum or rhodium catalysts in an ammonia-containing atmosphere.

The platinum catalysts and rhodium catalysts operative in the present invention include, but are not limited to, (CH₃CH₂S)₂PtCl₂, platinum acetylacetonate, and rhodium catalyst RhCl₃(CH₃CH₂CH₂CH₂S)₃, obtained from Dow Corning Corporation, Midland, Michigan. Any platinum or rhodium compound or complex which can be solubilized in the hydrogen silsesquioxane resin will serve to catalyze the cure and is within the scope of this patent.

Sample formulations of the planarizing coatings of the instant invention include, but are not limited to, those depicted in Table I.

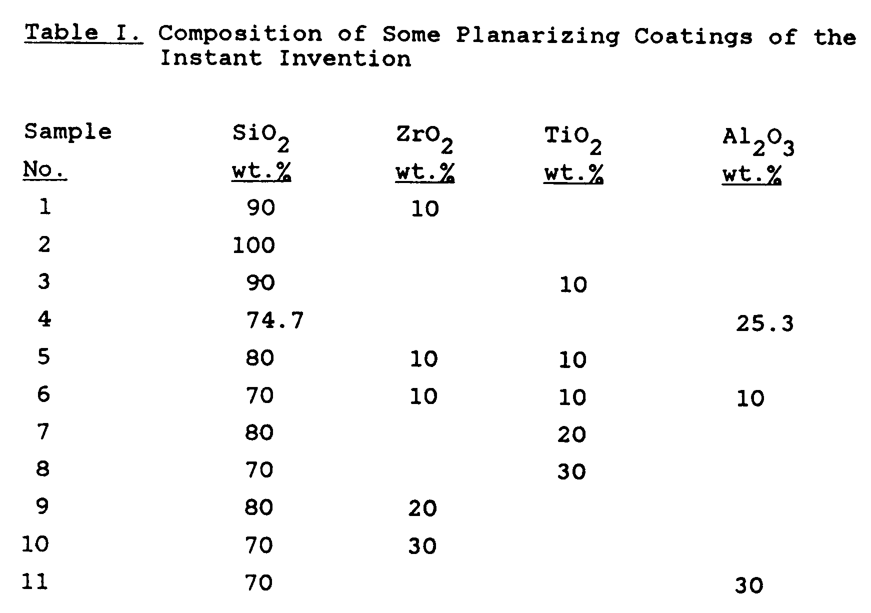

where wt% is weight per cent; ZrO₂ is zirconium dioxide produced from zirconium alkoxide; TiO₂ is titanium dioxide produced from titanium alkoxide; Al₂O₃ is aluminum oxide produced from aluminum pentanedionate.

While Table I indicates a metal alkoxide composition in the coatings of 10 weight per cent, the concentration range of metal oxide may vary from 0.1 weight per cent metal alkoxide up to approximately 30 weight percent. By varying the ratio of hydrogen silsesquioxane resin to metal alkoxide (and thus to the resulting metal oxide) specific formulations with desired coefficients of thermal expansion (CTE) can be designed. It is desirable in coating electronic devices that the CTE of the coating allow for sufficient thermal expansion so as to minimize the formation of microcracks upon exposure of the coated device to temperature variations. Table II shows the CTE values for several common ceramic materials used in coating electronic devices and also the CTE values of ceramic planarizing coatings of the instant invention.

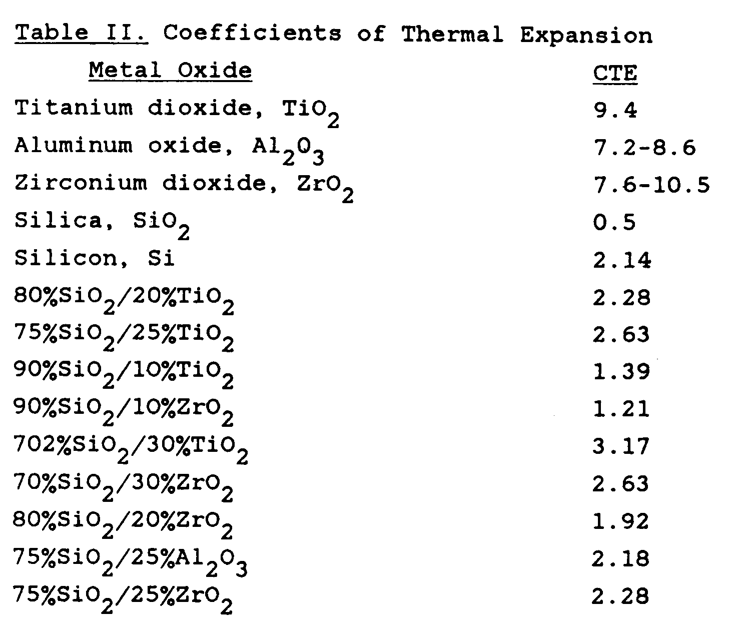

The source for the reference data appearing above is "Ceramic Source", American Chemical Society, vol. 1., 1985, p. 350-1. The CTE values for the compositions of the instant invention are calculated.

The chemical compounds in which the aluminum, zirconium, and titanium are operative in the present invention are not limited to the oxide or dioxide forms listed above but include any and all forms and mixtures of the metals which can be blended with the hydrogen silsesquioxane resin and ceramified to produce the mixed oxide planarizing coating system of the instant invention.

The second and passivating silicon nitrogen-containing layer of the composite coatings in the instant invention provides resistance against ionic impurities. Preceramic silicon nitrogen-containing polymers suitable for use in this present invention are well known in the art, including, but not limited to, silazanes, disilazanes, polysilazanes, cyclic silazanes and other silicon nitrogen-containing materials. The preceramic silicon nitrogen-containing polymers suitable for use in this invention must be capable of being converted to a ceramic or ceramic-like material at elevated temperatures. Mixtures of preceramic silazane polymers and/or other silicon- and nitrogen-containing materials may also be used in this invention. Examples of preceramic silazane polymers or polysilazanes suitable for use in this invention include polysilazanes as described by Gaul in U S. Patents 4,312,970 (issued January 26, 1982), 4,340,619 (issued July 20, 1982), 4,395,460 (issued July 26, 1983), and 4,404,153 (issued September 13, 1983). Suitable polysilazanes also include those described by Haluska in U.S. Patent 4,482,689 (issued November 13, 1984) and by Seyferth et al. in U.S. Patent 4,397,828 (issued August 9, 1983), and Seyferth et al. in U.S. Patent 4,482,669 (issued November, 13, 1984). Other polysilazanes suitable for use in this invention are disclosed by Cannady in U.S. Patents 4,540,803 (issued September 10, 1985), 4,535,007 (issued August 13, 1985), and 4,543,344 (issued September 24, 1985), and by Baney et al. in U.S. Patent Application Serial No. 652,939, filed September 21, 1984 (corresponding to EP-A2-0 175 384). Also suitable for use in this invention are dihydridosilazane polymers prepared by the reaction of H₂SiX₂, where X = a halogen atom, and NH₃. These (H₂SiNH)ₙ polymers are well known in the art, but have not been used for the protection of electronic devices. (See, for example, Seyferth, U.S. Patent No. 4,397,828, issued August 9, 1983).

Also to be included as preceramic silicon nitrogen-containing polymer materials useful within the scope of the present invention are the novel preceramic polymers derived from cyclic silazanes and halogenated disilanes, and also the novel preceramic polymers derived from cyclic silazanes and halosilanes. These materials are disclosed and claimed in US Patent No 4 745 205 titled "Novel preceramic Polymers Derived From Cyclic Silazanes And Halogenated Disilanes And A Method For Their Preparation", US Patent No 4 742 143 titled "Novel Preceramic Polymers Derived From Cyclic Silazanes And Halosilanes And A Method For Their Preparation", respectively, filed in the name of Loren A. Haluska. The above-described novel preceramic silicon nitrogen-containing polymers derived from cyclic silazanes and halosilanes and/or halogenated disilanes are also useful for the protection of any substrate able to withstand the temperatures necessary for ceramification of the preceramic polymers. Still other silicon- and nitrogen-containing materials may be suitable for use in the present invention.

A preferred temperature range for ceramifying or partially ceramifying the silicon nitrogen-containing preceramic polymer is from 200 to 400°C. A more preferred temperature range for ceramifying the silicon nitrogen-containing preceramic polymer is from 300 to 400°C. However, the method of applying the heat for the ceramification or partial ceramification of the silicon nitrogen-containing coating is not limited to conventional thermal methods. The silicon nitrogen-containing polymer coatings useful as planarizing and passivating coatings in the instant invention can also be cured by other radiation means, such as, for example, exposure to a laser beam. However, the present invention is not limited to ceramification temperatures below 400°C. Ceramification techniques utilizing temperatures up to and including at least 1000°C. will be obvious to those skilled in the art, and are useful in the present invention where the substrate can withstand such temperatures.

By "cure" in the present invention is meant coreaction and ceramification or partial ceramification of the starting material by heating to such an extent that a solid polymeric ceramic or ceramic-like coating material is produced.

Alternatively, in the three layer coating of the instant invention, the second and passivating coating can be selected from the group consisting of silicon nitrogen-containing material, silicon carbon nitrogen-containing material, and silicon carbon-containing material. The silicon nitrogen-containing material is deposited by the CVD or plasma enhanced CVD of the reaction product formed by reacting silane halosilanes, halopolysilanes, or halodisilanes and ammonia. The silicon carbon-containing material is deposited by the CVD or plasma enhanced CVD of the reaction product formed by reacting silane, halosilanes, halopolysilanes, or halodisilanes and an alkane of one to six carbon atoms or alkylsilane. The silicon carbon nitrogen-containing material is deposited by the CVD or PECVD of hexamethyldisilazane or the CVD or PECVD of mixtures of a silane, an alkylsilane, an alkane of one to six carbon atoms, and ammonia.

The second and passivating coating of the multilayer coatings of the instant invention can be produced by applying to the planarizing coating a passivating ceramic or ceramiclike coating selected from the group consisting of (i) a silicon nitrogen-containing coating, (ii) a silicon carbon-containing coating, and (iii) a silicon carbon nitrogen-containing coatings wherein the silicon nitrogen-containing coating is applied onto the ceramic or ceramic-like coated electronic device by a means selected from the group consisting of (a) chemical vapor deposition of a silane, halosilane, halodisilane, halopolysilane or mixtures thereof in the presence of ammonia, (b) plasma enhanced chemical vapor deposition of a silane, halosilane, halodisilane, halopolysilane or mixtures thereof in the presence of ammonia, (c) ceramification of a silicon and nitrogen-containing preceramic polymer; and wherein the silicon carbon nitrogen-containing coating is applied onto the ceramic or ceramic-like coated electronic device by a means selected from the group consisting of (1) chemical vapor deposition of hexamethyldisilazane, (2) plasma enhanced chemical vapor deposition of hexamethyldisilazane, (3) chemical vapor deposition of a silane, alkylsilane, halosilane, halodisilane, halopolysilane or mixture thereof in the presence of an alkane of one to six carbon atoms or an alkylsilane and further in the presence of ammonia, and (4) plasma enhanced chemical vapor deposition of a silane, alkylsilane, halosilane, halodisilane, halopolysilane or mixture thereof in the presence of an alkane of one to six carbon atoms or an alkylsilane and further in the presence of ammonia; and wherein the silicon carbon-containing coating is deposited by a means selected from the group consisting of (i) chemical vapor deposition of a silane, alkylsilane, halosilane, halodisilane, halopolysilane or mixtures thereof in the presence of an alkane of one to six carbon atoms or an alkylsilane and (ii) plasma enhanced chemical vapor deposition of a silane, alkylsilane, halosilane, halodisilane, halopolysilane or mixtures thereof in the presence of an alkane of one to six carbon atoms or an alkylsilane, to produce the passivating ceramic or ceramic-like coating.

The preceramic silazane or other silicon nitrogen-containing polymer solvent solution is coated (by any method discussed above) onto the electronic device previously coated with the ceramified HSiO_{3/2}/metal alkoxide coating, such as, HSiO_{3/2}/Zr(OCH₂CH₂CH₃)₄ resin or HSiO_{3/2}/Zr(OCH₂CH₂CH₃)₄/Ti(OCH₂CH₂CH₂CH₃)₄ resin and the solvent allowed to evaporate by drying. By this means is deposited a preceramic polymer coating which is ceramified by heating the coated device for approximately one hour at temperatures up to 400°C. under argon. Thin ceramic passivating coatings of less than 2 µm (2 microns), for example approximately 0.5 µm (5000 Angstroms) are thus produced on the devices.

The third layer of the multilayer coatings of the instant invention can be produced by applying to the passivating ceramic or ceramic-like coating a silicon-containing coating selected from the group consisting of (i) a silicon coating, (ii) a silicon carbon containing coating, (iii) a silicon nitrogen-containing coating, and (iv) a silicon carbon nitrogen-containing coating, wherein the silicon coating is applied onto the passivating coating by a means selected from the group consisting of (a) chemical vapor deposition of a silane, halosilane, halodisilane, halopolysilane or mixtures thereof, (b) plasma enhanced chemical vapor deposition of a silane, halosilane, halodisilane, halopolysilane or mixtures thereof, or (c) metal assisted chemical vapor deposition of a silane, halosilane, halodisilane, halopolysilane or mixtures thereof, and wherein the silicon carbon-containing coating is applied by a means selected from the group consisting of (1) chemical vapor deposition of a silane, halosilane, halodisilane, halopolysilane or mixtures thereof in the presence of an alkane of one to six carbon atoms or an alkylsilane, (2) plasma enhanced chemical vapor deposition of a silane, alkylsilane, halosilane, halodisilane, halopolysilane or mixtures thereof in the presence of an alkane of one to six carbon atoms or an alkylsilane; and wherein the silicon nitrogen-containing coating is deposited by a means selected from the group consisting of (A) chemical vapor deposition of a silane, halosilane, halodisilane, halopolysilane or mixtures thereof in the presence of ammonia, (B) plasma enhanced chemical vapor deposition of a silane, halosilane, halodisilane, halopolysilane or mixtures thereof in the presence of ammonia, and (C) ceramification of a silicon and nitrogen-containing preceramic polymer, and wherein the silicon carbon nitrogen-containing coating is deposited by a means selected from the group consisting of (i) chemical vapor deposition of hexamethyldisilazane, (ii) plasma enhanced chemical vapor deposition of hexamethyldisilazane, (iii) chemical vapor deposition of a silane, alkylsilane, halosilane, halodisilane, halopolysilane or mixture thereof in the presence of an alkane of one to six carbon atoms or an alkylsilane and further in the presence of ammonia, and (iv) plasma enhanced chemical vapor deposition of a silane, alkylsilane, halosilane, halodisilane, halopolysilane or mixture thereof in the presence of an alkane of one to six carbon atoms or an alkylsilane and further in the presence of ammonia; to produce the silicon-containing coating on the electronic device. The silicon-containing protective third layer or topcoat of the composite coatings of the present invention can be obtained at relatively low reaction temperature by the metal-assisted CVD process claimed in the parallel U.S. U.S Patent No. 4 696 834 filed February 2, 1986 in the name of Sudarsanan Varaprath and entitled "Silicon-containing Coatings and a Method for Their Preparation ", or by conventional non-metal assisted CVD and plasma enhanced CVD techniques. The high temperature conditions of the conventional CVD technique normally limit the type of substrate materials which can be coated. Thus, electronic devices which cannot be heated over 400°C. without damage cannot be coated by conventional CVD techniques. The choice of substrates and devices to be coated by the instant invention is limited only by the need for thermal and chemical stability of the substrate at the lower decomposition temperature in the atmosphere of the decomposition vessel.

Coatings produced by the instant invention posses low defect density and are useful on electronic devices as protective coatings, as corrosion resistant and abrasion resistant coatings, as temperature and moisture resistant coatings, as dielectric layers, and as a diffusion barrier against ionic impurities such as Na+ and Cl-. The SiO₂/metal oxide coatings and the silicon nitrogen-containing ceramic or ceramic-like coatings of the instant invention are also useful as interlevel dielectrics within the body of the electronic device and between the metallization layers, thereby replacing spin-on glass films.

The coatings of the present invention are useful for functional purposes in addition to protection of electronic devices from the environment. The coatings of the present invention are also useful as dielectric layers, doped dielectric layers to produce transistor-like devices, pigment loaded binder systems containing silicon to produce capacitors and capacitor-like devices, multilayer devices, 3-D devices, silicon-on-insulator (SOI) devices, and super lattice devices.

### Example 1

A preceramic polymer containing hydrogen silsesquioxane resin, (HSiO_{3/2})ₙ, produced by the method of Frye et al., supra, was diluted in n-heptane and mixed at a 9:1 molar ratio with tetra n-propoxy zirconium, Zr(OCH₂CH₂CH₃)₄, to a final solids concentration of 1.0 weight per cent. The solvent solution was catalyzed by adding 0.01 grams of toluene in which was dissolved 60 parts per million of (CH₃CH₂S)₂PtCl₂. This catalyzed preceramic polymer solvent solution was allowed to remain at room temperature for 24 hours. The diluted catalyzed preceramic polymer solvent solution was then flow coated onto a CMOS electronic device and the solvent allowed to evaporate by drying. By this means was deposited a preceramic polymer coating which was ceramified by heating the coated device in a two inch Lindberg furnace for approximately twenty hours at 200°C. Additional coatings were also ceramified at 400°C. for one hour. Thin ceramic planarizing coatings of less than 2 µm (2 microns), which on measurement were approximately 0.4 µm (4000 A) were thus produced on the devices.

### Example 2

A preceramic polymer mixture containing 90% hydrogen silsesquioxane resin, (HSiO_{3/2})ₙ, and 10% tetra isobutoxy titanium, Ti(OCH₂CH(CH₃)₂)₄, was prepared in n-heptane at a concentration of 1 weight per cent. The preceramic solution was catalyzed by adding 0.01 grams of 0.5% solution in n-heptane of rhodium catalyst RhCl₃(CH₃CH₂CH₂CH₂S)₃, obtained from Dow Corning Corporation as DC2-7039. The catalyzed diluted preceramic polymer solution was allowed to stand at room temperature for 24 hours. The diluted catalyzed preceramic polymer solvent solution was then flow coated onto an electronic device and the solvent allowed to evaporate by drying. By this means was deposited a catalyzed preceramic polymer coating which was ceramified by heating the coated device for approximately twenty hours at 200°C. or for one hour at 400°C. Thin ceramic planarizing coatings of less than 2 µm (2 microns) which on measurement were approximately 0.4 µm (4000 A) were thus produced on the devices.

### Example 3

A preceramic polymer mixture containing 80% hydrogen silsesquioxane resin, (HSiO_{3/2})ₙ, 10% tetra isobutoxy titanium, Ti(OCH₂C(CH₃)₂)₄, and 10% tetra n-propoxy zirconium, Zr(OCH₂CH₂CH₃)₄, was prepared at low solids, 1.0 weight per cent, in methyl ethyl ketone. The preceramic polymer solvent solution was catalyzed by the method of Example 1, above, and allowed to stand at room temperature for 24 hours. The dilute catalyzed preceramic polymer solvent solution was then flow coated onto an electronic device and the solvent allowed to evaporate by drying. By this means was deposited a catalyzed preceramic polymer coating which was ceramified by heating the coated device for approximately twenty hours at 200°C. or for one hour at 400°C. Thin ceramic planarizing coatings of less than 2 µm (2 microns) which on measurement were approximately 0.4 µm (4000 Angstroms) were thus produced on the devices.

### Example 4

A preceramic polymer mixture containing 70% hydrogen silsesquioxane resin, (HSiO_{3/2})ₙ, 10% tetra isobutoxy titanium, Ti(OCH₂C(CH₃)₂)₄, 10% tetra n-propoxy zirconium, Zr(OCH₂CH₂CH₃)₄, and 10% aluminum pentanedionate, Al(CH₃COCH₂COCH₃)₃ was prepared at low solids, 1.0 weight per cent, in methyl ethyl ketone. The preceramic polymer solvent solution was catalyzed by the method of Example 2, above, and allowed to stand at room temperature for 24 hours. The dilute catalyzed preceramic polymer solvent solution was then flow coated onto an electronic device and the solvent allowed to evaporate by drying. By this means was deposited a catalyzed preceramic polymer coating which was ceramified by heating the coated device for approximately twenty hours at 200°C. or for one hour at 400°C. Thin ceramic planarizing coatings of less than 2 µm (2 microns) which on measurement were approximately 0.4 µm (4000 Angstroms), were thus produced on the devices.

### Example 5

A preceramic silazane polymer, prepared by the method of Cannady in Example 1 in U.S. Patent No. 4,540,803, was diluted to 1.0 weight per cent in toluene. The diluted preceramic silazane polymer solvent solution was then flow coated onto the coated electronic devices of Examples 1 through 4 and the solvent was allowed to evaporate by drying in the absence of air. By this means was deposited a preceramic polymer passivating coating which was ceramified by heating the coated device for approximately one hour at 400°C. under argon. Thin silicon nitrogen-containing ceramic or ceramic-like passivating coatings of less than 2 µm (2 microns) which on measurement were approximately 0.3 µm (3000 Angstroms) were thus produced on the devices.

### Example 6

Using the procedure of Example 5, a preceramic silazane polymer containing about 5 per cent titanium, prepared by the method of Haluska in Example 13 in U.S. Patent No. 4,482,689, was flow coated onto the SiO₂/metal oxide coated electronic device and the solvent allowed to evaporate by drying. By this means was deposited a preceramic polymer coating which was ceramified by heating the coated device for approximately one hour at temperatures up to 400°C. under argon. Thin silicon nitrogen-containing ceramic or ceramic-like passivating coatings of less than 2 µm (2 microns) which on measurement were approximately 0.3 µm (3000 Angstroms) were thus produced on the devices.

### Example 7

Using the procedure of Example 5, a preceramic silazane polymer, prepared by the method of Gaul in Example 1 in U.S. Patent No. 4,395,460, was coated onto the SiO₂/metal oxide coated electronic device and the solvent allowed to evaporate by drying. By this means was deposited a preceramic polymer coating which was ceramified by heating the coated device for approximately one hour at temperatures up to 400°C. under argon. Thin silicon nitrogen-containing ceramic or ceramic-like passivating coatings of less than 2 µm (2 microns) which on measurement were approximately 0.3 µm (3000 Angstroms), were thus produced on the devices.

### Example 8

A 1-2 weight percent solution in diethyl ether of dihydridosilazane polymer, prepared by the method of Seyferth in Example 1 in U.S. Patent 4,397,828, was flow coated onto CMOS devices coated by the methods of Examples 1-4, above. The coated devices were heated in nitrogen for one hour at 400°C. The coating and pyrolysis treatment did not adversely affect the function of the devices, as determined by a CMOS circuit tester. The coated devices withstood 0.1M NaCl exposure for over four and one half hours before circuit failure. A nonprotected CMOS device will fail to function after exposure to a 0.1M NaCl solution for less than one minute.

### Example 9

The electronic devices coated with the planarizing and/or passivating coatings of Examples 1 through 8 were then overcoated with the barrier coats as follows: Hexafluorodisilane, 66,661 kPa (500 Torr), was placed in a Pyrex (Trade Mark) glass reaction container along with a CMOS electronic device, previously coated as above. The hexafluorodisilane was transferred to the glass container in such a manner as to preclude exposure to the atmosphere. The reaction container was then attached to a vacuum line, the contents evacuated, and the container thoroughly heated under vacuum with a gas-oxygen torch. The container was sealed with a natural gas-oxygen torch and heated in an oven for 30 minutes at a temperature of approximately 360°C. During this time, the hexafluorodisilane starting material decomposed and formed a silicon-containing topcoat on the previously coated electronic device. The reaction by-products, mixtures of various halosilanes, and any unreacted starting material were removed by evacuation after the container had been reattached to the vacuum line. The ceramic coated electronic device, onto which the decomposed hexafluorodisilane starting material had deposited a silicon-containing topcoating, was then removed.

### Example 10

Using the procedure described in Example 9, dichlorodisilane was thermally decomposed in the presence of the ceramic or ceramic-like silicon nitrogen-containing coated electronic device. An amorphous silicon-containing topcoat was thereby deposited onto the ceramic or ceramic-like coated electronic device. The coated electronic device was tested and all electronic circuits were operable.

## Claims

1. A process for forming on a substrate a ceramic or ceramic-like coating wherein the coating is a monolayer and the process comprises:
(A) coating a substrate with a preceramic planarizing coating by means of diluting with a solvent a mixture of hydrogen silsesquioxane resin and a metal oxide precursor selected from the group consisting of an aluminum alkoxide, a titanium alkoxide, and a zirconium alkoxide, catalyzing the diluted mixture solution with a metal catalyst selected from the group consisting of platinum catalysts and rhodium catalysts, and applying the catalyzed diluted preceramic mixture solution to the substrate;
(B) drying the catalyzed diluted preceramic mixture solution so as to evaporate the solvent and thereby deposit a catalyzed metal oxide precursor/hydrogen silsesquioxane resin preceramic coating on the substrate;
(C) ceramifying the catalyzed preceramic coating to silicon dioxide and metal oxide by heating the coated device to a temperature between 150 and 1000°C. to thereby produce on the substrate a monolayer, ceramic or ceramic-like, planarizing coating.

2. A process for forming on a substrate a ceramic or ceramic-like coating according to claim 1, wherein the coating is a dual layer and the process comprises:
(I) carrying out steps (A), (B) and (C) according to claim 1; and
(II) applying to the ceramic or ceramic-like planarizing coating a passivating coating selected from the group consisting of (i) silicon nitrogen-containing coating, (ii) silicon carbon-containing coating, and (iii) silicon carbon nitrogen-containing coating, wherein the silicon nitrogen-containing coating is applied onto the planarizing coating of the substrate by a means selected from the group consisting of (a) chemical vapor deposition of a silane, halosilane, halodisilane, halopolysilane or mixtures thereof in the presence of ammonia, (b) plasma enhanced chemical vapor deposition of a silane, halosilane, halodisilane, halopolysilane or mixtures thereof in the presence of ammonia, (c) ceramificiation of a silicon and nitrogen-containing preceramic polymer; and wherein the silicon carbon nitrogen-containing coating is applied onto the ceramic or ceramic-like coated substrate by a means selected from the group consisting of (1) chemical vapor deposition of hexamethyldisilazane, (2) plasma enhanced chemical vapor deposition of hexamethyldisilazane, (3) chemical vapor deposition of a silane, alkylsilane, halosilane, halodisilane, halopolysilane or mixture thereof in the presence of an alkane of one to six carbon atoms or an alkylsilane and further in the presence of ammonia, and (4) plasma enhanced chemical vapor deposition of a silane, alkylsilane, halosilane, halodisilane, halopolysilane or mixture thereof in the presence of an alkane of one to six carbon atoms or an alkylsilane and further in the presence of ammonia; and wherein the silicon carbon-containing coating is deposited by a means selected from the group consisting of (i) chemical vapor deposition of an alkylsilane, silane, halosilane, halodisilane, halopolysilane or mixtures thereof in the presence of an alkane of one to six carbon atoms or an alkylsilane and (ii) plasma enhanced chemical vapor deposition of an alkylsilane, silane, halosilane, halodisilane, halopolysilane or mixtures thereof in the presence of an alkane of one to six carbon atoms or alkylsilane, to produce the passivating ceramic or ceramic-like coating, whereby a dual layer, ceramic or ceramic-like coating is obtained on the substrate.

3. A process for forming on a substrate a ceramic or ceramic-like coating according to claim 1, wherein the coating is a multilayer and the process comprises:
effecting steps (I) and (II) according to claim 2, and
(III) applying to the passivating ceramic or ceramic-like coating a silicon containing coating selected from the group consisting of (i) silicon coating, (ii) silicon carbon-containing coating, (iii) silicon nitrogen-containing coating, and (iv) silicon carbon nitrogen coating, wherein the silicon coating is applied onto the passivating coating by a means selected from the group consisting of (a) chemical vapor deposition of a silane, halosilane, halodisilane, halopolysilane or mixtures thereof, (b) plasma enhanced chemical vapor deposition of a silane, halosilane, halodisilane, halopolysilane or mixtures thereof, or (c) metal assisted chemical vapor deposition of a halosilane, halodisilane, halopolysilane or mixtures thereof, and wherein the silicon carbon coating is applied by a means selected from the group consisting of (1) chemical vapor deposition of a silane, alkylsilane, halosilane, halodisilane, halopolysilane or mixtures thereof in the presence of an alkane of one to six carbon atoms or an alkylsilane, (2) plasma enhanced chemical vapor deposition of an alkylsilane, halosilane, halodisilane, halopolysilane or mixtures thereof in the presence of an alkane of one to six carbon atoms or an alkylsilane; and wherein the silicon nitrogen-containing coating is deposited by a means selected from the group consisting of (A) chemical vapor deposition of a silane, halosilane, halodisilane, halopolysilane or mixtures thereof in the presence of ammonia, (B) plasma enhanced chemical vapor deposition of a silane, halosilane, halodisilane, halopolysilane or mixtures thereof in the presence of ammonia, and (C) ceramification of a silicon and nitrogen-containing preceramic polymer, and wherein the silicon carbon nitrogen-containing coating is deposited by a means selected from the group consisting of (i) chemical vapor deposition of hexamethyldisilazane, (ii) plasma enhanced chemical vapor deposition of hexamethyldisilazane, (iii) chemical vapor deposition of a silane, alkylsilane, halosilane, halodisilane,halopolysilane or mixture thereof in the presence of an alkane of one to six carbon atoms or an alkylsilane and further in the presence of ammonia, and (iv) plasma enhanced chemical vapor deposition of a silane, alkylsilane, halosilane, halodisilane, halopolysilane or mixture thereof in the presence of an alkane of one to six carbon atoms or an alkylsilane and further in the presence of ammonia, to produce the silicon-containing coating, whereby a multilayer, ceramic or ceramic-like, coating is obtained on the substrate.

4. A process for forming on a substrate a ceramic or ceramic-like coating according to claim 1 wherein the coating is a multilayer and the process comprises:
(I) carrying out steps (A),(B) and (C) according to claim 1; and
(II) applying to ceramic or ceramic-like coated substrate a silicon-containing coating by means of decomposing in a reaction chamber a silane, halosilane, halodisilane, halopolysilane, or mixture thereof in the vapor phase, at a temperature between 200 and 600°C., in the presence of the ceramic coated substrate, whereby a substrate containing a multilayer, ceramic or ceramic-like coating thereon is obtained.

5. A process for forming on a substrate a ceramic or ceramic-like coating according to claim 1, wherein the coating is a multilayer and the process comprises:
(I) carrying out steps (A), (B) and (C) according to claim 1; and
(II) applying to the ceramic or ceramic-like coated substrate a silicon nitrogen-containing coating by means of decomposing in a reaction chamber a silane, halosilane, halodisilane, halopolysilane, or mixture thereof, and ammonia, in the vapor phase, at a temperature between 150 and 1000°C., in the presence of the ceramic or ceramic-like coated substrate, whereby a substrate containing a multilayer, ceramic or ceramic-like coating thereon is obtained.

6. A process for forming on a substrate a ceramic or ceramic-like coating, according to claim 1, wherein the coating is a multilayer and wherein the process comprises:
(I) carrying out steps (A), (B) and (C) according to claim 1, and
(II) applying to the ceramic or ceramic-like coated substrate a silicon carbon-containing coating by means of decomposing in a reaction chamber an alkylsilane, silane, halosilane, halodisilane, halopolysilane, or mixture thereof, and an alkane of one to six carbon atoms or alkylsilane, in the vapor phase, at a temperature between 150 and 1000°C., in the presence of the ceramic or ceramic-like coated substrate, whereby a substrate containing a multilayer, ceramic or ceramic-like coating thereon is obtained.

7. A process for forming on a substrate a ceramic or ceramic-like coating according to claim 1, wherein the coating is a multilayer and wherein the process comprises:
(I) carrying out steps (A), (B) and (C) according to claim 1; and
(II) applying to the ceramic or ceramic-like coated substrate a silicon carbon nitrogen-containing coating by means of decomposing in a reaction chamber hexamethyldisilazane, in the vapor phase, at a temperature between 150 and 1000°C., in the presence of the ceramic or ceramic-like substrate, whereby a substrate containing a multilayer, ceramic or ceramic-like coating thereon is obtained.

8. A process for forming on a substrate a ceramic or ceramic-like coating according to claim 1, wherein the process is a multilayer and wherein the process comprises:
(I) carrying out steps (A), (B) and (C) according to claim 1;
(II) applying to the ceramic or ceramic-like coating on the substrate a passivating coating comprising a silicon nitrogen-containing material produced by means of diluting in a solvent a preceramic silicon nitrogen-containing polymer, coating the ceramic or ceramic-like coated substrate with the diluted preceramic silicon nitrogen-containing polymer solution, drying the diluted preceramic silicon nitrogen-containing polymer solution so as to evaporate the solvent and thereby deposit a preceramic silicon nitrogen-containing coating on the ceramic or ceramic-like coated substrate, heating the coated substrate to a temperature of 150 to 1000°C in an inert or ammonia-containing atmosphere to produce a ceramic silicon nitrogen-containing coating, and
(III) applying to the ceramic or ceramic-like coating on the substrate a silicon-containing coating by means of decomposing in a reaction chamber a silane, halosilane, halodisilane or mixture thereof in the vapor phase, at a temperature between 200 and 600°C., in the presence of the ceramic or ceramic-like coated substrate, whereby a substrate containing a multilayer, ceramic or ceramic-like coating thereon is obtained.

9. A process for forming on a substrate a ceramic or ceramic-like coating according to claim 1, wherein the coating is a multilayer and wherein the process comprises:
(I) carrying out steps (A), (B) and (C) according to claim 1;
(II) applying to the ceramic or ceramic-like coated substrate a passivating coating comprising a silicon nitrogen-containing material produced by means of diluting in a solvent a preceramic silicon nitrogen-containing polymer, coating the ceramic ceramic-like coated substrate with the diluted preceramic silicon nitrogen-containing polymer solution, drying the diluted preceramic silicon nitrogen-containing polymer solution so as to evaporate the solvent and thereby deposit a preceramic silicon nitrogen-containing coating on the ceramic or ceramic-like coated substrate, heating the coated substrate to a temperature between 150 and 1000°C in an inert or ammonia-containing atmosphere to produce a ceramic silicon nitrogen-containing coating, and
(III) applying to the ceramic or ceramic-like coated substrate a silicon nitrogen-containing coating by means of decomposing in a reaction chamber a silane, halosilane, halodisilane, halopolysilane or mixture thereof, and ammonia, in the vapor phase, at a temperature between 150 and 1000°C in the presence of the ceramic or ceramic-like coated substrate whereby a substrate containing a multilayer, ceramic or ceramic-like coating thereon is obtained.

10. A process for forming on a substrate a ceramic or ceramic-like coating according to claim 1, wherein the coating is a multilayer and wherein the process comprises:
(I) carrying out steps (A), (B) and (C) according to claim 1;
(II) applying to the ceramic or ceramic-like coated substrate a passivating coating comprising a silicon nitrogen-containing material produced by means of diluting in a solvent a preceramic silicon nitrogen-containing polymer, coating the ceramic or ceramic-like coated substrate with the diluted preceramic silicon nitrogen-containing polymer solution, drying the diluted preceramic silicon nitrogen-containing polymer solution so as to evaporate the solvent and thereby deposit a preceramic silicon nitrogen-containing coating on the ceramic or ceramic-like coated substrate, heating the coated substrate to a temperature between 150 and 1000°C. in an inert or ammonia-containing atmosphere to produce a ceramic or ceramic-like silicon nitrogen-containing coating, and
(III) applying to the ceramic or ceramic-like coated substrate a silicon carbon-containing coating by means of decomposing in a reaction chamber an alkylsilane, silane, halosilane, halodisilane, halopolysilane or mixture thereof, and an alkane of one to six carbon atoms or an alkylsilane, in the vapor phase, at a temperature between 150 and 1000°C., in the presence of the ceramic or ceramic coated substrate whereby a substrate containing a multilayer, ceramic or ceramic-like coating thereon is obtained.

11. A process for forming on a substrate a ceramic or ceramic-like coating according to claim 1, wherein the coating is a multilayer and wherein the process comprises:
(I) carrying out steps (A), (B) and (C) according to claim 1 .
(II) applying to the ceramic or ceramic-like coated substrate a passivating coating comprising a silicon nitrogen-containing material produced by means of diluting in a solvent a preceramic silicon nitrogen-containing polymer, coating the ceramic or ceramic-like coated substrate with the diluted preceramic silicon nitrogen-containing polymer solution, drying the diluted preceramic silicon nitrogen-containing polymer solution so as to evaporate the solvent and thereby deposit a preceramic silicon nitrogen-containing coating on the ceramic or ceramic-like coated substrate device, heating the coated device to a temperature between 150 and 1000°C in an inert or ammonia-containing atmosphere to produce a ceramic or ceramic-like silicon nitrogen-containing coating, and
(III) applying to the ceramic or ceramic-like coated substrate a silicon carbon nitrogen-containing coating by means of chemical vapor deposition of hexamethyldisilazane, at a temperature between 150 and 1000°C, in the presence of the ceramic or ceramic-like coated substrate, whereby a substrate containing a multilayer, ceramic or ceramic-like coating thereon is obtained.

12. A process for forming on a substrate a ceramic or ceramic-like coating according to claim 1, wherein the coating is a multilayer and wherein the process comprises:
(I) carrying out steps (A), (B) and (C) according to claim 1;
(II) applying to the ceramic or ceramic-like coated substrate a passivating coating comprising a silicon nitrogen-containing material produced by means of diluting in a solvent a preceramic silicon nitrogen-containing polymer, coating the ceramic or ceramic-like coated substrate with the diluted preceramic silicon nitrogen-containing polymer solution, drying the diluted preceramic silicon nitrogen-containing polymer solution so as to evaporate the solvent and thereby deposit a preceramic silicon nitrogen-containing coating on the ceramic or ceramic-like coated electronic substrate, heating the coated substrate to a temperature between 150 and 1000°C. in an inert or ammonia-containing atmosphere to produce a ceramic or ceramic-like silicon nitrogen-containing coating, and
(III) applying to the ceramic or ceramic-like coated substrate a silicon carbon nitrogen-containing coating by means of plasma enhanced chemical vapor deposition of hexamethyldisilazane, at a temperature between 150 and 1000°C., in the presence of the ceramic or ceramic-like coated substrate, whereby a substrate containing a multilayer, ceramic or ceramic-like coating thereon is obtained.

13. A process for forming on a substrate a ceramic or ceramic-like coating according to claim 1, wherein the coating is a dual layer and wherein the process comprises:
(I) carrying out steps (A), (B), and (C) according to claim 1; and
(II) applying to the ceramic or ceramic-like coated substrate a passivating coating comprising a silicon nitrogen-containing material produced by means of diluting in a solvent a preceramic silicon nitrogen-containing polymer, coating the ceramic or ceramic-like coated substrate with the diluted preceramic silicon nitrogen-containing polymer solution, drying the diluted preceramic silicon nitrogen-containing polymer solution so as to evaporate the solvent and thereby deposit a preceramic silicon nitrogen-containing coating on the ceramic or ceramic-like coating of the substrate, and heating the coated substrate to a temperature between 150 and 1000°C. in an inert or ammonia-containing atmosphere to produce a passivating silicon nitrogen-containing coating, thereby producing a dual layer, ceramic or ceramic-like coating on the substrate.

14. A process for forming on a substrate a ceramic or ceramic-like coating according to any of claims 1 to 13 wherein the substrate is an electronic device.

## Patentansprüche

1. Verfahren zur Erzeugung einer keramischen oder keramikartigen Beschichtung auf einem Substrat, wobei die Beschichtung aus nur einer Schicht besteht und das Verfahren dadurch gekennzeichnet ist, daß man
(A) ein Substrat mit einer präkeramischen, eben machenden Beschichtung versieht, indem man ein Gemisch aus einem Wasserstoffsilsesquioxanharz und, als Vorläuferverbindung für ein Metalloxid, einem Aluminiumalkoxid, einem Titanalkoxid und/oder einem Zirkoniumalkoxid mit einem Lösungsmittel verdünnt, die verdünnte Lösung des Gemisches mit einem Platin- und/oder Rhodiumkatalysator versetzt und die katalysierte verdünnte Lösung des präkeramischen Gemisches auf das Substrat aufbringt;
(B) die katalysierte verdünnte präkeramische Lösung des Gemisches durch Verdampfen des Lösungsmittels trocknet und dadurch auf dem Substrat eine präkeramische Beschichtung aus einem katalysiertem Gemisch aus Metalloxidvorläuferverbindung und Wasserstoffsilsesquioxanharz erzeugt;
(C) die katalysierte präkeramische Beschichtung durch Erhitzen des beschichteten Gegenstandes auf eine Temeratur zwischen 150 und 1.000 °C zu Siliziumdioxid und Metalloxid keramisiert und dadurch auf dem Substrat eine aus nur einer Schicht bestehende keramische oder keramikartige, eben machende Beschichtung erzeugt.

2. Verfahren zur Erzeugung einer keramischen oder keramikartigen Beschichtung auf einem Substrat nach Anspruch 1, wobei die Beschichtung aus zwei Schichten besteht und das Verfahren dadurch gekennzeichnet ist, daß man
(I) die Verfahrensschritte (A), (B), und (C) gemäß Anspruch 1 durchführt; und
(II) auf die keramische oder keramikartige, eben machende Beschichtung als passivierende Schicht (i) eine Silizium und Stickstoff enthaltende Beschichtung, (ii) eine Silizium und Kohlenstoff enthaltende Beschichtung und /oder (iii) eine Silizium, Kohlenstoff und Stickstoff enthaltende Beschichtung aufbringt,
wobei man die passivierende Beschichtung auf die eben machende Beschichtung des Substrats aufbringt, indem man (a) ein Silan, Halogensilan, Halogendisilan, Halogenpolysilan oder ein Gemisch dieser Stoffe in Gegenwart von Ammoniak in der Dampfphase chemisch niederschlägt, (b) ein Silan, Halogensilan, Halogendisilan, Halogenpolysilan oder ein Gemisch dieser Stoffe in Gegenwart von Ammoniak und mit Plasmaunterstüzung aus der Dampfphase chemisch niederschlägt und/oder (c) ein Silizium und Stickstoff enthaltendes präkeramisches Polymeres keramisiert;
wobei die Silizium, Kohlenstoff und Stickstoff enthaltende Beschichtung auf das keramisch oder keramikartig beschichtete Substrat aufgebracht wird, indem man (1) Hexamethyldisilazan aus der Dampfphase chemisch niederschlägt, (2) Hexamethyldisilazan aus der Dampfphase mit Plasmaunterstützung chemisch niederschlägt, (3) ein Silan, Alkylsilan, Halogensilan, Halogendisilan, Halogenpolysilan oder ein Gemisch dieser Stoffe in Gegenwart eines Alkans mit ein bis sechs Kohlenstoffatomen oder eines Alkylsilans sowie in Gegenwart von Ammoniak aus der Dampfphase chemisch niederschlägt und bzw. oder (4) ein Silan, Alkylsilan, Halogensilan, Halogendisilan, Halogenpolysilan oder ein Gemisch dieser Stoffe in Gegenwart eines Alkans mit 1 bis 6 Kohlenstoffatomen oder eines Alkylsilans sowie in Gegenwart von Ammoniak mit Plasmaunterstützung aus der Dampphase chemisch niederschlägt; und
wobei man die Silizium und Kohlenstoff enthaltende Beschichtung aufbringt, indem man (i) ein Alkylsilan, Silan, Halogensilan, Halogendisilan, Halogenpolysilan oder ein Gemisch dieser Stoffe in Gegenwart eines Alkans mit ein bis sechs Kohlenstoffatomen oder eines Alkylsilans aus der Dampfphase chemisch niederschlägt, (ii) ein Alkylsilan, Silan, Halogensilan, Halogendisilan, Halogenpolysilan oder ein Gemisch dieser Stoffe in Gegenwart eines Alkans mit ein bis sechs Kohlenstoffatomen oder eines Alkylsilans mit Plasmaunterstützung aus der Dampfphase chemisch niederschlägt und dadurch die passivierende keramische oder präkeramische Schicht erzeugt,
wodurch eine aus zwei Schichten bestehende, keramische oder präkeramische Beschichtung auf dem Substrat entsteht.

3. Verfahren zur Erzeugung einer keramischen oder keramikartigen Beschichtung auf einem Substrat nach Anspruch 1, wobei die Beschichtung aus mehreren Schichten besteht und das Verfahren dadurch gekennzeichnet ist, daß man
die Verfahrensschritte (I) und (II) gemäß Anspruch 2 durchführt, und
(III) auf die passivierende keramische oder keramikartige Beschichtung als eine Silizium enthaltende Beschichtung (i) eine Siliziumbeschichtung, (ii) eine Silizium und Kohlenstoff enthaltende Beschichtung, (iii) eine Silizium und Stickstoff enthaltende Beschichtung, und/oder (iv) eine Silizium, Kohlenstoff und Stickstoff enthaltende Beschichtung aufbringt;
wobei die Siliziumbeschichtung auf die passivierende Beschichtung aufgebracht wird, indem man (a) ein Silan, Halogensilan, Halogendisilan, Halogenpolysilan oder ein Gemisch dieser Stoffe aus der Dampfphase chemisch niederschlägt, (b) ein Silan, Halogensilan, Halogendisilan, Halogenpolysilan oder ein Gemisch dieser Stoffe aus der Dampfphase mit Plasmaunterstützung chemisch niederschlägt und/oder (c) ein Halogensilan, Halogendisilan, Halogenpolysilan oder ein Gemisch dieser Stoffe aus der Dampfphase mit Unterstützung durch ein Metall chemisch niederschlägt,
wobei die Silizium und Kohlenstoff enthaltende Beschichtung aufgebracht wird, indem man (1) ein Silan, Alkylsilan, Halogensilan, Halogendisilan, Halogenpolysilan oder ein Gemisch dieser Stoffe in Gegenwart eines Alkans mit ein bis sechs Kohlenstoffatomen oder eines Alkylsilans aus der Dampfphase chemisch niederschlägt, (2) ein Silan, Alkylsilan, Halogensilan, Halogendisilan, Halogenpolysilan oder ein Gemisch dieser Stoffe in Gegenwart eines Alkans mit ein bis sechs Kohlenstoffatomen oder eines Alkylsilans aus der Dampfphase mit Plasmaunterstützung chemisch niederschlägt;
wobei die Silizium und Stickstoff enthaltende Beschichtung aufgebracht wird, indem man (A) ein Silan, Halogensilan, Halogendisilan, Halogenpolysilan oder ein Gemisch dieser Stoffe in Gegenwart von Ammoniak aus der Dampfphase chemisch niederschlägt, (B) ein Silan, Halogensilan, Halogendisilan, Halogenpolysilan oder ein Gemisch dieser Stoffe in Gegenwart von Ammoniak aus der Dampfphase mit Plasmaunterstützung chemisch niederschlägt und/oder (C) ein Silzium und Stickstoff enthaltendes präkeramisches Polymer keramisiert; und
wobei die Silizium, Kohlenstoff und Stickstoff enthaltenden Beschichtung aufgebracht wird, indem man (i) Hexamethyldisilazan aus der Dampfphase chemisch niederschlägt, (ii) Hexamethyldisilazan aus der Dampfphase mit Plasmaunterstützung chemisch niederschlägt, (iii) ein Silan, Alkylsilan, Halogensilan, Halogendisilan, Halogenpolysilan oder ein Gemisch dieser Stoffe in Gegenwart eines Alkans mit ein bis sechs Kohlenstoffatomen oder eines Alkylsilans sowie in Gegenwart von Ammoniak aus der Dampfphase chemisch niederschlägt und bzw. oder (iv) ein Silan, Alkylsilan, Halogensilan, Halogendisilan, Halogenpolysilan oder ein Gemisch dieser Stoffe in Gegenwart eines Alkans mit ein bis sechs Kohlenstoffatomen oder eines Alkylsilans sowie in Gegenwart von Ammoniak aus der Dampfphase mit Plasmaunterstützung chemisch niederschlägt,
und dadurch eine keramische oder keramikartige Beschichtung aus mehreren Schichten auf dem Substrat erzeugt.

4. Verfahren zur Erzeugung einer keramischen oder keramikartigen Beschichtung auf einem Substrat nach Anspruch 1, wobei die Beschichtung aus mehreren Schichten besteht und das Verfahren dadurch gekennzeichnet ist, daß man
(I) die Verfahrensschritte (A), (B) und (C) gemäß Anspruch 1 durchführt; und
(II) auf das keramisch oder keramikartig beschichtete Substrat eine Silizium enthaltende Beschichtung aufbringt, indem man in einer Reaktionskammer ein Silan, Halogensilan, Halogendisilan, Halogenpolysilan oder ein Gemisch dieser Stoffe in der Dampfphase bei einer Temperatur zwischen 200 und 600°C in Gegenwart des keramisch oder keramikartig beschichteten Substrats zersetzt, wodurch ein Substrat mit einer aus mehreren Schichten bestehenden keramischen oder keramikartigen Beschichtung erhalten wird.

5. Verfahren zur Erzeugung einer keramischen oder keramikartigen Beschichtung auf einem Substrat nach Anspruch 1, wobei die Beschichtung aus mehreren Schichten besteht und das Verfahren dadurch gekennzeichnet ist, daß man
(I) die Verfahrensschritte (A), (B) und (C) gemäß Anspruch 1 durchführt; und
(II) auf das keramisch oder keramikartig beschichtete Substrat eine Silizium und Stickstoff enthaltende Beschichtung aufbringt, indem man in einer Reaktionskammer ein Silan, Halogensilan, Halogendisilan, Halogenpolysilan oder ein Gemisch dieser Stoffe sowie Ammoniak in Gegenwart des keramisch oder keramikartig beschichteten Substrats in der Dampfphase bei einer Temperatur zwischen 150 und 1.000°C zersetzt, wodurch ein Substrat mit einer aus mehreren Schichten bestehenden keramischen oder keramikartigen Beschichtung entsteht.

6. Verfahren zur Erzeugung einer keramischen oder Keramikartigen Beschichtung auf einem Substrat nach Anspruch 1, wobei die Beschichtung aus mehreren Schichten besteht und das Verfahren dadurch gekennzeichnet ist, daß man
(I) die Verfahrensschritte (A), (B) und (C) gemäß Anspruch 1 durchführt, und
(II) auf das keramisch oder keramikartig beschichtete Substrat eine Silizium und Kohlenstoff enthaltende Schicht aufbringt, indem man in einer Reaktionskammer ein Alkylsilan, Silan, Halogensilan, Halogendisilan, Halogenpolysilan oder ein Gemisch dieser Stoffe sowie ein Alkan mit ein bis sechs Kohlenstoffatomen oder ein Alkylsilan in Gegenwart des keramisch oder keramikartig beschichteten Substrats in der Dampfphase bei einer Temperatur zwischen 150 und 1.000°C zersetzt, wodurch ein Substrat mit einer aus mehreren Schichten bestehenden keramischen oder keramikartigen Beschichtung entsteht.

7. Verfahren zur Erzeugung einer keramischen oder keramikartigen Beschichtung auf einem Substrat nach Anspruch 1, wobei die Beschichtung aus mehreren Schichten besteht und das Verfahren dadurch gekennzeichnet ist, daß man
(I) die Verfahrensschritte (A), (B) und (C) gemäß Anspruch 1 durchführt; und
(II) auf das keramisch oder keramikartig beschichtete Substrat eine Silizium, Kohlenstoff und Stickstoff enthaltende Schicht aufbringt, indem man in einer Reaktionskammer Hexamethyldisilazan in Gegenwart des keramisch oder keramikartig beschichteten Substrats in der Dampfphase bei einer Temperatur zwischen 150 und 1.000°C zersetzt, wodurch eine Substrat mit einer aus mehreren Schichten bestehenden keramischen oder keramikartigen Beschichtung entsteht.

8. Verfahren zur Erzeugung einer keramischen oder keramikartigen Beschichtung auf einem Substrat nach Anspruch 1, wobei die Beschichtung aus mehreren Schichten besteht und das Verfahren dadurch gekennzeichnet ist, daß man
(I) die Verfahrensschritte (A), (B) und (C) gemäß Anspruch 1 durchführt;
(II) auf das keramisch oder keramikartig beschichtete Substrat eine passivierende, Silizium und Stickstoff enthaltende Schicht aufbringt, indem man ein präkeramisches, Silizium und Stickstoff enthaltendes Polymer in einem Lösungsmittel löst, das keramisch oder keramikartig beschichtet Substrat mit der Lösung des präkeramischen, Silizium und Stickstoff enthaltenden Polymeren beschichtet, die Lösung des präkeramischen, Silizium und Stickstoff enthaltenden Polymeren zur Trockene bringt, so daß das Lösungsmittel verdampft und dadurch eine präkeramische, Silizium und Stickstoff enthaltende Schicht auf dem keramisch oder keramikartig beschichteten Substrat verbleibt, das beschichtete Substrat in einer inerten oder Ammoniak enthaltenden Atmosphäre auf eine Temperatur zwischen 150 und 1.000°C erhitzt und dadurch eine keramische, Silizium und Stickstoff enthaltende Schicht erzeugt; und
(III) auf die keramische oder keramikartige Beschichtung auf dem Substrat eine Silizium enthaltende Schicht aufbringt, indem man in einer Reaktionskammer ein Silan, Halogensilan, Halogendisilan, Halogenpolysilan oder ein Gemisch dieser Stoffe in Gegenwart des keramisch oder keramikartig beschichteten Substrats in der Dampfphase bei einer Temperatur zwischen 200 und 600°C zersetzt , wodurch eine Substrat mit einer aus mehreren Schichten bestehenden keramischen oder keramikartigen Beschichtung entsteht.

9. Verfahren zur Erzeugung einer keramischen oder keramikartigen Beschichtung auf einem Substrat nach Anspruch 1, wobei die Beschichtung aus mehreren Schichten besteht und das Verfahren dadurch gekennzeichnet ist, daß man
(I) die Verfahrensschritte (A), (B) und (C) gemäß Anspruch 1 durchführt;
(II) auf das keramisch oder keramikartig beschichtete Substrat eine passivierende, Silizium und Stickstoff enthaltende Schicht aufbringt, indem man ein präkeramisches, Silizium und Stickstoff enthhaltende Polymeres in einem Lösiungsmittel löst, das keramisch oder keramikartig beschichtete Substrat mit der Lösung des präkeramischen, Silizium und Stickstoff enthaltenden Polymeren beschichtet, die Lösung des präkeramischen, Silizium und Stickstoff enthaltenden Polymeren zur Trockne bringt, so daß das Lösungsmittel verdampft und eine präkeramische, Slizium und Stickstoff enthaltende Schicht auf dem keramisch oder keramikartig beschichteten Substrat verbleibt, das beschichtete Substrat in einer inerten oder Ammoniak enthaltenden Atmosphäre auf eine Temperatur zwischen 150 und 1.000°C erhitzt, wodurch eine keramische, Silizium und Stickstoff enthaltende Schicht entsteht, und
(III) auf das keramisch oder keramikartig beschichtete Substrat eine Silizium und Stickstoff enthaltende Schicht aufbringt, indem man in einer Reaktionskammer ein Silan, Halogensilan, Halogendisilan, Halogenpolysilan oder ein Gemisch dieser Stoffe sowie Ammoniak in Gegenwart des keramisch oder keramikartig beschichteten Substrats in der Dampfphase bei einer Temperatur zwischen 150 und 1.000°C zersetzt, wodurch ein Substrat mit einer aus mehreren Schichten bestehenden keramischen oder keramikartigen Beschichtung entsteht.

10. Verfahren zur Erzeugung einer keramischen oder keramikartigen Beschichtung auf einem Substrat nach Anspruch 1, wobei die Beschichtung aus mehreren Schichten besteht und das Verfahren dadurch gekennzeichnet ist, daß man
(I) die Verfahrensschritte (A), (B) und (C) gemäß Anspruch 1 durchführt;
(II) auf das keramisch oder keramikartig beschichtete Substrat eine passivierende, Silizium und Stickstoff enthaltende Schicht aufbringt, indem man ein präkeramisches, Silizium und Stickstoff enthaltendes Polymeres in einem Lösungsmittel löst, das keramisch oder keramikartig beschichtete Substrat mit der Lösung des präkeramischen, Silizium und Stickstoff enthaltenden Polymeren beschichtet, die Lösung des präkeramischen, Silizium und Stickstoff enthaltenden Polymeren zur Trockne bringt, so daß das Lösungsmittel verdampft und eine präkeramische, Silizium und Stickstoff enthaltende Schicht auf dem keramisch oder keramikartig beschichteten Substrat verbleibt, das beschichtete Substrat in einer inerten oder Ammoniak enthaltenden Atmosphäre auf eine Temperatur zwischen 150 und 1.000°C erhitzt, so daß eine keramische oder keramikartige Schicht entsteht, und
(III) auf das keramisch oder keramikartig beschichtete Substrat eine Silizium und Kohlenstoff enthaltende Schicht aufbringt, indem man in einer Reaktionskammer ein Alkylsilan, Silan, Halogensilan, Halogendisilan, Halogenpolysilan oder ein Gemisch dieser Stoffe sowie ein Alkan mit ein bis sechs Kohlenstoffatomen oder ein Alkylsilan in Gegenwart des keramisch oder keramikartig beschichteten Substrats in der Dampfphase bei einer Temperatur zwischen 150 und 1.000°C zersetzt, so daß ein Substrat mit einer aus mehreren Schichten bestehenden, keramischen oder keramikartigen Beschichtung entsteht.

11. Verfahren zur Erzeugung einer keramischen oder keramikartigen Beschichtung auf einem Substrat nach Anspruch 1, wobei die Beschichtung aus mehreren Schichten besteht und das Verfahren dadurch gekennzeichnet ist, daß man
(I) die Verfahrensschritte (A), (B) und (C) gemäß Anspruch 1 durchführt;
(II) auf das keramisch oder keramikartig beschichtete Substrat eine passivierende, Silizium und Stickstoff enthaltende Schicht aufbringt, indem man ein präkeramisches, Silizium und Stickstoff enthaltendes Polymeres in einem Lösungsmittel löst, das keramisch oder keramikartig beschichtete Substrat mit der Lösung des präkeramischen, Silizium und Stickstoff enthaltenden Polymeren beschichtet, die Lösung des präkeramischen, Silizium und Stickstoff enthaltenden Polymeren zur Trockne bringt, so daß das Lösungsmittel verdampft und eine präkeramische, Silizium und Stickstoff enthaltende Schicht auf dem keramisch oder keramikartig beschichteten Substrat verbleibt, das beschichtete Substrat in einer inerten oder Ammoniak enthaltenden Atmosphäre auf eine Temperatur zwischen 150 und 1.000°C erhitzt, wodurch eine keramische oder keramikartige, Silizium und Stickstoff enthaltende Schicht entsteht; und
(III) auf das keramisch oder keramikartig beschichtete Substrat eine Silizium, Kohlenstoff und Stickstoff enthaltende Schicht aufbringt, indem man Hexamethyldisilazan in Gegenwart des keramisch oder keramikartig beschichteten Substrats bei einer Temperatur zwischen 150 und 1.000°C zersetzt, wodurch ein Substrat mit einer aus mehreren Schichten bestehenden, keramischen oder keramikartigen Beschichtung entsteht.

12. Verfahren zur Erzeugung einer keramischen oder keramikartigen Beschichtung auf einem Substrat nach Anspruch 1, wobei die Beschichtung aus mehreren Schichten besteht und das Verfahren dadurch geknnzeichnet ist, daß man
(I) die Verfahrensschritte (A), (B) und (C) gemäß Anspruch 1 durchführt;
(II) auf das keramisch oder keramikartig beschichtete Substrat eine passivierende, Silizium und Stickstoff enthaltende Schicht aufbringt, indem ein präkeramisches, Silizium und Stickstoff enthaltendes Polymeres in einem Lösungsmittel löst, das keramisch oder keramikartig beschichtete Substrat mit der Lösung des präkeramischen, Silizium und Stickstoff enthatenden Polymeren beschichtet, die Lösung des präkeramischen, Silizium und Stickstoff enthaltenden Polymeren zur Trockne bringt, so daß das Lösungsmittel verdampft und eine präkeramische, Silizium und Stickstoff enthaltende Schicht auf dem keramisch oder keramikartig beschichteten elektronischen Substrat verbleibt, das beschichtete Substrat in einer inerten oder Ammoniak enthaltenden Atmosphäre auf eine Temperatur zwischen 150 und 1.000°C erhitzt, wodurch eine keramische oder keramikartige, Silizium und Stickstoff enthaltende Schicht entsteht, und
(III) auf das keramisch oder keramikartig beschichtete Substrat eine passivierende, Silizium, Kohlenstoff und Stickstoff enthaltende Schicht aufbringt, indem man Hexamethyldisilazan bei einer Temperatur zwischen 150 und 1.000°C aus der Dampfphase mit Plasmaunterstützung auf dem keramisch oder keramikartig beschichteten Substrat niederschlägt, wodurch ein Substrat mit einer keramischen oder keramikartigen Beschichtung entsteht;

13. Verfahren zur Erzeugung einer keramischen oder keramikartigen Beschichtung auf einem Substrat nach Anspruch 1, wobei die Beschichtung aus zwei Schichten besteht und das Verfahren dadurch gekennzeichnet ist, daß man
(I) die Verfahrensschritte (A), (B) und (C) gemäß Anspruch 1 durchführt; und
(II) auf das keramisch oder keramikartig beschichtete Substrat eine passivierende, Silizium und Stickstoff enthaltende Schicht aufbringt, indem man ein präkeramisches, Silizium und Stickstoff enthaltendes Polymeres in einem Lösungsmittel löst, das keramisch oder keramikartig beschichtete Substrat mit der Lösung des präkeramischen, Silizium und Stickstoff enthaltenden Polymeren beschichtet, die Lösung des präkeramischen, Silizium und Stickstoff enthaltenden Polymeren zur Trockne bringt, so daß das Lösungsmittel verdampft und eine präkeramische, Silizium und Stickstoff enthaltende Schicht auf der keramischen oder keramikartigen Beschichtung des Substrats verbleibt und das beschichtete Substrat in einer inerten oder Ammoniak enthaltenden Atmosphäre auf eine Temperatur zwischen 150 und 1.000°C erhitzt, wodurch eine passivierende, Silizium und Stickstoff enthaltende Schicht erzeugt wird und eine aus zwei Schichten bestehende, keramische oder keramikartige Beschichtung auf des Substrat entsteht.

14. Verfahren zur Erzeugung einer keramischen oder keramikartigen Beschichtung auf einem Substrat nach einem der Ansprüche 1 bis 13, wobei das Substrat eine elektronische Vorrichtung ist.

## Revendications

1. Un procédé pour former sur un substrat un revêtement céramique ou de type céramique, dans lequel le revêtement est une monocouche et le procédé consiste à :
(A) revêtir un substrat avec un revêtement d'aplanissement précéramique par dilution avec un solvant d'un mélange de résine d'hydrogénosilsesquioxane et d'un précurseur d'oxyde de métal choisi dans le groupe formé par un alcoolate d'aluminium, un alcoolate de titane et un alcoolate de zirconium, catalyse de la solution du mélange dilué avec un catalyseur à base de métal choisi dans le groupe formé par les catalyseurs au platine et les catalyseurs au rhodium, et application au substrat de la solution catalysée de mélange précéramique dilué ;
(B) sécher la solution catalysée de mélange précéramique dilué de manière à évaporer le solvant et déposer ainsi un revêtement précéramique catalysé de précurseur d'oxyde de métal/résine d'hydrogénosilsesquioxane sur le substrat ;
(C) transformer en matière céramique le revêtement précéramique catalysé en formant du bioxyde de silicium et un oxyde de métal par chauffage du dispositif revêtu à une température comprise entre 150 et 1000°C, pour produire ainsi sur le substrat un revêtement d'aplanissement monocouche céramique ou de type céramique.

2. Un procédé pour former sur un substrat un revêtement céramique ou de type céramique selon la revendication 1, dans lequel le revêtement est une double couche et le procédé consiste à :
(I) effectuer les étapes (A), (B) et (C) selon la revendication 1 ; et
(II) appliquer au revêtement d'aplanissement céramique ou de type céramique un revêtement de passivation choisi dans le groupe formé par (i) un revêtement contenant du silicium et de l'azote, (ii) un revêtement contenant du silicium et du carbone et (iii) un revêtement contenant du silicium, du carbone et de l'azote, le revêtement contenant du silicium et de l'azote étant appliqué sur le revêtement d'aplanissement du substrat par un moyen choisi dans le groupe formé par (a) le dépôt chimique en phase vapeur d'un silane, halogénosilane, halogénodisilane, halogénopolysilane ou mélange d'entre eux en présence d'ammoniac, (b) le dépôt chimique en phase vapeur activé par plasma d'un silane, halogénosilane, halogénodisilane, halogénopolysilane ou mélange d'entre eux en présence d'ammoniac, (c) la transformation en matière céramique d'un polymère précéramique contenant du silicium et de l'azote ; et le revêtement contenant du silicium, du carbone et de l'azote étant appliqué sur le substrat portant le revêtement céramique ou de type céramique par un moyen choisi dans le groupe formé par (1) le dépôt chimique en phase vapeur d'hexaméthyldisilazane, (2) le dépôt chimique en phase vapeur activé par plasma d'hexaméthyldisilazane, (3) le dépôt chimique en phase vapeur d'un silane, alkylsilane, halogénosilane, halogénodisilane, halogénopolysilane ou mélange d'entre eux en présence d'un alcane de un à six atomes de carbone ou d'un alkylsilane et également en présence d'ammoniac, et (4) le dépôt chimique en phase vapeur activé par plasma d'un silane, alkylsilane, halogénosilane, halogénodisilane, halogénopolysilane ou mélange d'entre eux en présence d'un alcane de un à six atomes de carbone ou d'un alkylsilane et également en présence d'ammoniac ; et le revêtement contenant du silicium et du carbone étant déposé par un moyen choisi dans le groupe formé par (i) le dépôt chimique en phase vapeur d'un alkylsilane, silane, halogénosilane, halogénodisilane, halogénopolysilane ou mélange d'entre eux en présence d'un alcane de un à six atomes de carbone ou d'un alkylsilane, et (ii) le dépôt chimique en phase vapeur activé par plasma d'un alkylsilane, silane, halogénosilane, halogénodisilane, halogénopolysilane ou mélange d'entre eux en présence d'un alcane de un à six atomes de carbone ou d'un alkylsilane, pour produire le revêtement de passivation céramique ou de type céramique, pour obtenir ainsi un revêtement céramique ou de type céramique à double couche sur le substrat.

3. Un procédé pour former sur un substrat un revêtement céramique ou de type céramique selon la revendication 1, dans lequel le revêtement est une couche multiple et le procédé consiste à :
effectuer les étapes (I) et (II) selon la revendication 2, et
(III) appliquer au revêtement de passivation céramique ou de type céramique un revêtement contenant du silicium choisi dans le groupe formé par (i) un revêtement de silicium, (ii) un revêtement contenant du silicium et du carbone, (iii) un revêtement contenant du silicium et de l'azote et (iv) un revêtement contenant du silicium, du carbone et de l'azote, le revêtement de silicium étant appliqué sur le revêtement de passivation par un moyen choisi dans le groupe formé par (a) le dépôt chimique en phase vapeur d'un silane, halogénosilane, halogénodisilane, halogénopolysilane ou mélange d'entre eux, (b) le dépôt chimique en phase vapeur activé par plasma d'un silane, halogénosilane, halogénodisilane, halogénopolysilane ou mélange d'entre eux, et (c) le dépôt chimique en phase vapeur assisté par métal d'un halogénosilane, halogénodisilane, halogénopolysilane ou mélange d'entre eux, et le revêtement contenant du silicium et du carbone étant appliqué par un moyen choisi dans le groupe formé par (1) le dépôt chimique en phase vapeur d'un silane, alkylsilane, halogénosilane, halogénodisilane, halogénopolysilane ou mélange d'entre eux en présence d'un alcane de un à six atomes de carbone ou d'un alkylsilane, (2) le dépôt chimique en phase vapeur activé par plasma d'un alkylsilane, halogénosilane, halogénodisilane, halogénopolysilane ou mélange d'entre eux en présence d'un alcane de un à six atomes de carbone ou d'un alkylsilane ; et le revêtement contenant du silicium et de l'azote étant déposé par un moyen choisi dans le groupe formé par (A) le dépôt chimique en phase vapeur d'un silane, halogénosilane, halogénodisilane, halogénopolysilane ou mélange d'entre eux en présence d'ammoniac, (B) le dépôt chimique en phase vapeur activé par plasma d'un silane, halogénosilane, halogénodisilane, halogénopolysilane ou mélange d'entre eux en présence d'ammoniac, (C) la transformation en matière céramique d'un polymère précéramique contenant du silicium et de l'azote ; et le revêtement contenant du silicium, du carbone et de l'azote étant déposé par un moyen choisi dans le groupe formé par (i) le dépôt chimique en phase vapeur d'hexaméthyldisilazane, (ii) le dépôt chimique en phase vapeur activé par plasma d'hexaméthyldisilazane, (iii) le dépôt chimique en phase vapeur d'un silane, alkylsilane, halogénosilane, halogénodisilane, halogénopolysilane ou mélange d'entre eux en présence d'un alcane de un à six atomes de carbone ou d'un alkylsilane et également en présence d'ammoniac, et (iv) le dépôt chimique en phase vapeur activé par plasma d'un silane, alkylsilane, halogénosilane, halogénodisilane, halogénopolysilane ou mélange d'entre eux en présence d'un alcane de un à six atomes de carbone ou d'un alkylsilane et également en présence d'ammoniac, pour produire le revêtement contenant du silicium, pour obtenir ainsi revêtement multicouche céramique ou de type céramique sur le substrat.

4. Un procédé pour former sur un substrat un revêtement céramique ou de type céramique selon la revendication 1, dans lequel le revêtement est une couche multiple et le procédé consiste à :
(I) effectuer les étapes (A), (B) et (C) selon la revendication 1 ; et
(II) appliquer au substrat portant le revêtement céramique ou de type céramique un revêtement contenant du silicium par décomposition dans une chambre de réaction d'un silane, halogénosilane, halogénodisilane, halogénopolysilane ou mélange d'entre eux, en phase vapeur, à une température comprise entre 200 et 600°C, en présence du substrat portant le revêtement céramique, pour obtenir ainsi un substrat portant un revêtement multicouche céramique ou de type céramique.

5. Un procédé pour former sur un substrat un revêtement céramique ou de type céramique selon la revendication 1, dans lequel le revêtement est une couche multiple et le procédé consiste à :
(I) effectuer les étapes (A), (B) et (C) selon la revendication 1 ; et
(II) appliquer au substrat portant le revêtement céramique ou de type céramique un revêtement contenant du silicium et de l'azote par décomposition dans une chambre de réaction d'un silane, halogénosilane, halogénodisilane, halogénopolysilane ou mélange d'entre eux, et d'ammoniac, en phase vapeur, à une température comprise entre 150 et 1000°C, en présence du substrat portant le revêtement céramique ou de type céramique, pour obtenir ainsi un substrat portant un revêtement multicouche céramique ou de type céramique.

6. Un procédé pour former sur un substrat un revêtement céramique ou de type céramique selon la revendication 1, dans lequel le revêtement est une couche multiple et le procédé consiste à :
(I) effectuer les étapes (A), (B) et (C) selon la revendication 1 ; et
(II) appliquer au substrat portant le revêtement céramique ou de type céramique un revêtement contenant du silicium et du carbone par décomposition dans une chambre de réaction d'un alkylsilane, silane, halogénosilane, halogénodisilane, halogénopolysilane ou mélange d'entre eux, et d'un alcane de un à six atomes de carbone ou d'un alkylsilane, en phase vapeur, à une température comprise entre 150 et 1000°C, en présence du substrat portant le revêtement céramique ou de type céramique, pour obtenir ainsi un substrat portant un revêtement multicouche céramique ou de type céramique.

7. Un procédé pour former sur un substrat un revêtement céramique ou de type céramique selon la revendication 1, dans lequel le revêtement est une couche multiple et le procédé consiste à :
(I) effectuer les étapes (A), (B) et (C) selon la revendication 1 ; et
(II) appliquer au substrat portant le revêtement céramique ou de type céramique un revêtement contenant du silicium, du carbone et de l'azote par décomposition dans une chambre de réaction d'hexaméthyldisilazane, en phase vapeur, à une température comprise entre 150 et 1000°C, en présence du substrat portant le revêtement céramique ou de type céramique, pour obtenir ainsi un substrat portant un revêtement multicouche céramique ou de type céramique.

8. Un procédé pour former sur un substrat un revêtement céramique ou de type céramique selon la revendication 1, dans lequel le revêtement est une couche multiple et le procédé consiste à :
(I) effectuer les étapes (A), (B) et (C) selon la revendication 1 ;
(II) appliquer au revêtement céramique ou de type céramique sur le substrat un revêtement de passivation comprenant une matière contenant du silicium et de l'azote, produit par dilution dans un solvant d'un polymère précéramique contenant du silicium et de l'azote, enduction du substrat portant le revêtement céramique ou de type céramique avec la solution de polymère précéramique dilué contenant du silicium et de l'azote, séchage de la solution de polymère précéramique dilué contenant du silicium et de l'azote de manière à évaporer le solvant et déposer ainsi un revêtement précéramique contenant du silicium et de l'azote sur le substrat portant le revêtement céramique ou de type céramique, chauffage du substrat revêtu à une température comprise entre 150 et 1000°C dans une atmosphère inerte ou contenant de l'ammoniac pour produire un revêtement céramique contenant du silicium et de l'azote ; et
(III) appliquer au revêtement céramique ou de type céramique sur le substrat un revêtement contenant du silicium par décomposition dans une chambre de réaction d'un silane, halogénosilane, halogénodisilane ou mélange d'entre eux, en phase vapeur, à une température comprise entre 200 et 600°C, en présence du substrat portant le revêtement céramique ou de type céramique, pour obtenir ainsi un substrat portant un revêtement multicouche céramique ou de type céramique.

9. Un procédé pour former sur un substrat un revêtement céramique ou de type céramique selon la revendication 1, dans lequel le revêtement est une couche multiple et le procédé consiste à :
(I) effectuer les étapes (A), (B) et (C) selon la revendication 1 ;
(II) appliquer au substrat portant le revêtement céramique ou de type céramique un revêtement de passivation comprenant une matière contenant du silicium et de l'azote, produit par dilution dans un solvant d'un polymère précéramique contenant du silicium et de l'azote, enduction du substrat portant le revêtement céramique ou de type céramique avec la solution de polymère précéramique dilué contenant du silicium et de l'azote, séchage de la solution de polymère précéramique dilué contenant du silicium et de l'azote de manière à évaporer le solvant et déposer ainsi un revêtement précéramique contenant du silicium et de l'azote sur le substrat portant le revêtement céramique ou de type céramique, chauffage du substrat revêtu à une température comprise entre 150 et 1000°C dans une atmosphère inerte ou contenant de l'ammoniac pour produire un revêtement céramique contenant du silicium et de l'azote ; et
(III) appliquer au substrat portant le revêtement céramique ou de type céramique un revêtement contenant du silicium et de l'azote par décomposition dans une chambre de réaction d'un silane, halogénosilane, halogénodisilane, halogénopolysilane ou mélange d'entre eux et d'ammoniac, en phase vapeur, à une température comprise entre 150 et 1000°C, en présence du substrat portant le revêtement céramique ou de type céramique, pour obtenir ainsi un substrat portant un revêtement multicouche céramique ou de type céramique.

10. Un procédé pour former sur un substrat un revêtement céramique ou de type céramique selon la revendication 1, dans lequel le revêtement est une couche multiple et le procédé consiste à :
(I) effectuer les étapes (A), (B) et (C) selon la revendication 1 ;
(II) appliquer au substrat portant le revêtement céramique ou de type céramique un revêtement de passivation comprenant une matière contenant du silicium et de l'azote, produit par dilution dans un solvant d'un polymère précéramique contenant du silicium et de l'azote, enduction du substrat portant le revêtement céramique ou de type céramique avec la solution de polymère précéramique dilué contenant du silicium et de l'azote, séchage de la solution de polymère précéramique dilué contenant du silicium et de l'azote de manière à évaporer le solvant et déposer ainsi un revêtement précéramique contenant du silicium et de l'azote sur le substrat portant le revêtement céramique ou de type céramique, chauffage du substrat revêtu à une température comprise entre 150 et 1000°C dans une atmosphère inerte ou contenant de l'ammoniac pour produire un revêtement céramique ou de type céramique contenant du silicium et de l'azote ; et
(III) appliquer au substrat portant le revêtement céramique ou de type céramique un revêtement contenant du silicium et du carbone par décomposition dans une chambre de réaction d'un alkylsilane, silane, halogénosilane, halogénodisilane, halogénopolysilane ou mélange d'entre eux, et d'un alcane de un à six atomes de carbone ou d'un alkylsilane, en phase vapeur, à une température comprise entre 150 et 1000°C, en présence du substrat portant le revêtement céramique ou de type céramique, pour obtenir ainsi un substrat portant un revêtement multicouche céramique ou de type céramique.

11. Un procédé pour former sur un substrat un revêtement céramique ou de type céramique selon la revendication 1, dans lequel le revêtement est une couche multiple et le procédé consiste à :
(I) effectuer les étapes (A), (B) et (C) selon la revendication 1 ;
(II) appliquer au substrat portant le revêtement céramique ou de type céramique un revêtement de passivation comprenant une matière contenant du silicium et de l'azote, produit par dilution dans un solvant d'un polymère précéramique contenant du silicium et de l'azote, enduction du substrat portant le revêtement céramique ou de type céramique avec la solution de polymère précéramique dilué contenant du silicium et de l'azote, séchage de la solution de polymère précéramique dilué contenant du silicium et de l'azote de manière à évaporer le solvant et déposer ainsi un revêtement précéramique contenant du silicium et de l'azote sur le substrat portant le revêtement céramique ou de type céramique, chauffage du substrat revêtu à une température comprise entre 150 et 1000°C dans une atmosphère inerte ou contenant de l'ammoniac pour produire un revêtement céramique ou de type céramique contenant du silicium et de l'azote ; et
(III) appliquer au substrat portant le revêtement céramique ou de type céramique un revêtement contenant du silicium, du carbone et de l'azote par dépôt chimique en phase vapeur d'hexaméthyldisilazane, à une température comprise entre 150 et 1000°C, en présence du substrat portant le revêtement céramique ou de type céramique, pour obtenir ainsi un substrat portant un revêtement multicouche céramique ou de type céramique.

12. Un procédé pour former sur un substrat un revêtement céramique ou de type céramique selon la revendication 1, dans lequel le revêtement est une couche multiple et le procédé consiste à :
(I) effectuer les étapes (A), (B) et (C) selon la revendication 1 ;
(II) appliquer au substrat portant le revêtement céramique ou de type céramique un revêtement de passivation comprenant une matière contenant du silicium et de l'azote, produit par dilution dans un solvant d'un polymère précéramique contenant du silicium et de l'azote, enduction du substrat portant le revêtement céramique ou de type céramique avec la solution de polymère précéramique dilué contenant du silicium et de l'azote, séchage de la solution de polymère précéramique dilué contenant du silicium et de l'azote de manière à évaporer le solvant et déposer ainsi un revêtement précéramique contenant du silicium et de l'azote sur le substrat électronique portant le revêtement céramique ou de type céramique, chauffage du substrat revêtu à une température comprise entre 150 et 1000°C dans une atmosphère inerte ou contenant de l'ammoniac pour produire un revêtement céramique ou de type céramique contenant du silicium et de l'azote ; et
(III) appliquer au substrat portant le revêtement céramique ou de type céramique un revêtement contenant du silicium, du carbone et de l'azote par dépôt chimique en phase vapeur activé par plasma d'hexaméthyldisilazane, à une température comprise entre 150 et 1000°C, en présence du substrat portant le revêtement céramique ou de type céramique, pour obtenir ainsi un substrat portant un revêtement multicouche céramique ou de type céramique.

13. Un procédé pour former sur un substrat un revêtement céramique ou de type céramique selon la revendication 1, dans lequel le revêtement est une double couche et le procédé consiste à :
(I) effectuer les étapes (A), (B) et (C) selon la revendication 1 ;
(II) appliquer au substrat portant le revêtement céramique ou de type céramique un revêtement de passivation comprenant une matière contenant du silicium et de l'azote, produit par dilution dans un solvant d'un polymère précéramique contenant du silicium et de l'azote, enduction du substrat portant le revêtement céramique ou de type céramique avec la solution de polymère précéramique dilué contenant du silicium et de l'azote, séchage de la solution de polymère précéramique dilué contenant du silicium et de l'azote de manière à évaporer le solvant et déposer ainsi un revêtement précéramique contenant du silicium et de l'azote sur le revêtement céramique ou de type céramique du substrat, et chauffage du substrat revêtu à une température comprise entre 150 et 1000°C dans une atmosphère inerte ou contenant de l'ammoniac pour produire un revêtement de passivation contenant du silicium et de l'azote, pour produire ainsi un revêtement céramique ou de type céramique à double couche sur le substrat.

14. Un procédé pour former sur un substrat un revêtement céramique ou de type céramique selon l'une quelconque des revendications 1 à 13, dans lequel le substrat est un dispositif électronique.
